# EUROPEAN PATENT APPLICATION

(11) **EP 3 960 934 A1**
(43) Date of publication of application: **02.03.2022**
(21) Application number: 19926722.0
(22) Date of filing: 26.04.2019
(51) Int. Cl.: E02B 1/00

(54) **DETECTION AND CONFIRMATION SYSTEM FOR GROUNDWATER VEINS AND FOR GROUNDWATER IN GROUNDWATER VEINS**

(71) Applicant: The Water Inc., Fukuoka-shi Fukuoka, 810-0001 (JP)
(72) Inventor: TAKEMURA Kotaro, Tokyo 140-0011 (JP); FUSAMAE Tomoaki, Suita-shi Osaka 565-0851 (JP)
(74) Representative: Elzaburu S.L.P.
(86) International application number: PCT/JP2019/018148
(87) International publication number: WO 2020/217531

(57) **Abstract**

Problem to be Solved

The present invention provides a system which can detect/check an underground water vein in a specific ground area and detect/check underground water in the underground water vein at a pinpoint.

Solution

The present invention has, while two-dimensionally visualizing an underground water vein in a specific ground area, a large number of electrodes group 22 disposed in the specific ground area, a survey point switching unit 23 having two poles in an electrode 22a with four poles in dipole-dipole arrangement in the electrodes group 22 set to potential electrodes, while the other two poles as current electrodes and combining and switching them so as to execute horizontal exploration and underground vertical exploration, measuring means 25 for each survey point of the entire ground area, specific resistance calculating means 31 for each survey point for calculating a specific resistance value at each survey point for each of high and low two frequencies in the horizontal and vertical directions at each survey point of the ground area, and impedance effect is acquired for each survey point on the basis of the calculated specific resistance value for each of the high and low two frequencies at each survey point so that estimation that a survey point position with the impedance effect > 1 has an underground water vein can be made and displayed three-dimensionally.

## Description

### Technical Field

The present invention relates to a detection/check system of an underground water vein and underground water in the underground water vein and in more detail, relates to a detection/check system of an underground water vein and underground water in the underground water vein configured such that the underground water vein in a specific ground area is detected/checked and moreover, the underground water in the underground water vein in the detected/checked specific ground area can be detected/checked at a pinpoint by exploration from a ground surface.

### Background Art

Conventionally, geological surveying methods include a field of physical exploration using physical properties of a geological condition in general, and it includes electric exploration using electric properties.

In the electric exploration, a specific resistance method using specific resistance of the ground includes vertical exploration that captures a vertical change in a stratum and horizontal exploration that captures horizontal abnormality of a mineral vein, a geological fault and the like.

With the horizontal exploration, an effect combined with that of the vertical exploration can be exerted by a number of close measurements, and it is known that determination on presence of underground water and even a quantity of water intake can be made more clearly by images.

Patent Literature 1 discloses, as an art related to the present invention, a four-dimensional water circulation reproduction/analysis/prediction/visualization simulation system configured to reproduce/analyze/predict/visualize a four-dimensional water circulation state from the past to the future by storing a three-dimensional landform/geological feature model including the ground surface and the underground in a certain range of geosphere generated by using satellite image data, site survey data, and landform/geological feature data in a simulation result storage portion, by generating an initialization model for the underground of the three-dimensional landform/geological feature model, by executing calculation processing and image generation processing in accordance with an input of a parameter for reproduction of the past/modern and current times and future prediction for the initialization model so as to improve accuracy through modification of the landform/geological feature model and the like and to store a result in a simulation result storage portion, by executing processing of still images and moving images and displaying them on a display portion.

According to the art of this Patent Literature 1, though the underground water vein can be displayed multi-dimensionally and visualized, it was difficult to determine what position in the visualized underground water vein should be excavated (boring) at a pinpoint from a viewpoint of water use.

That is, according to the art of the Patent Literature 1, the underground water vein can be displayed planarly and two-dimensionally, but even if the underground water vein is simply visualized, what position to bore at a pinpoint in the visualized underground water vein in order to hit the underground water has actually depended on a hunch of a human being.

Patent Literature 2 discloses, as an art related to the present invention, a moisture detecting device for detecting moisture contained in a predetermined area under the ground and including a plurality of current electrode pairs for measuring a current value of an AC current input into the predetermined area, a plurality of potential electrode pairs for measuring a voltage value corresponding to the AC current, and frequency setting means for setting a plurality of frequencies for a frequency of the AC current at a predetermined frequency interval from a first frequency set in advance to a second frequency higher than the first frequency, specific resistance calculating means for acquiring a specific resistance value in the predetermined area by using the current value and the voltage value each time when the frequency is set by the frequency setting means, and estimating means for estimating that, by acquiring a maximum value and a minimum value of the specific resistance value, the smaller a quotient obtained by dividing the maximum value by the minimum value is, the larger the moisture contained in the predetermined area is.

According to the art of this Patent Literature 2, it is configured to be estimated that the smaller the quotient obtained by dividing the maximum value by the minimum value is, the larger the moisture contained in the predetermined area is by acquiring the maximum value and the minimum value of the specific resistance value, but such estimation is based on an experiment result, and it was difficult to detect/check the underground water in the underground water vein in the ground area at a pinpoint by simply using such a device without detection/check in advance.

### Citation List

### Patent Literature

Patent Literature 1: Japanese Patent Laid-Open No. 2014-37677
Patent Literature 2: Japanese Patent No. 6235146

### Summary of Invention

### Technical Problem

The present invention was developed in view of the aforementioned conventional circumstances and has an object to provide a detection/check system of underground water vein and underground water in the underground water vein so that the underground water in a specific ground area can be detected/checked and moreover, the underground water in the underground water vein in the detected/checked specific ground area can be detected/checked at a pinpoint by exploration from the ground surface.

That is, the present invention is a detection/check system of underground water vein and underground water in the underground water vein configured by combining each system art in Patent Literature 1 and Patent Literature 2 as the arts related to the present invention and a system for boring at a pinpoint by visualizing the underground water vein planarly and two-dimensionally by the art of Patent Literature 1 and by three-dimensionally displaying a position of the underground water in the visualized underground water vein.

### [Solution to Problem]

A detection/check system of an underground water vein and underground water in the underground water vein of the present invention is a system of visualizing the underground water vein planarly and two-dimensionally and of displaying a position of the underground water in the visualized underground water vein for boring at a pinpoint as described above three-dimensionally.

First, an art for visualizing the underground water vein planarly and two-dimensionally in the present invention is executed by storing a three-dimensional landform/geological feature model including the ground surface and the underground in a certain range of geosphere generated by using landform/geological feature data of satellite observation image data/site survey data/existing published data in storage means, characterized most mainly by generating an initialization model by executing initialization processing with the underground of the three-dimensional landform/geological feature model set to a saturated zone, by executing simulation by calculation processing by calculating means and image generation processing by image generation processing means in accordance with an input from input means of various parameters for reproduction of past/modern and current times and future prediction on the basis of execution of a simulation program to the initialization model, by storing a simulation result in the storage means, and by displaying those subjected to visualization processing into two-dimensional and three-dimensional still images and moving images on display means so as to reproduce/analyze/predict/visualize four-dimensional water circulation state in the certain range of the geosphere from the past to the future.

Moreover, the art in the present invention of three-dimensionally displaying the position of the underground water in the underground water vein obtained by visualizing the underground water vein planarly and two-dimensionally so as to enable boring at a pinpoint is characterized mainly by having a large number of electrodes group disposed along a survey line of a specific ground area, a survey point switching unit for executing horizontal exploration and underground vertical exploration of the specific ground area by a specific resistance method by combining and switching the electrode with four poles in dipole-dipole arrangement in the electrodes group, measuring means for applying a voltage made of high and low two frequencies to two poles in the electrode with four poles in the dipole-dipole arrangement and making measurement for detecting a current for each of the high and low two frequencies flowing between the two poles by the other two poles at each survey point of the entire specific ground area, specific resistance calculating means for each survey point for calculating a specific resistance value for each of the high and low two frequencies in the horizontal and vertical directions at each survey point in the corresponding specific ground area on the basis of the voltage made of the high and low two frequencies and the detected current for each of the high and low two frequencies, and impedance effect calculating means for each survey point for acquiring an impedance effect at each survey point, made of (specific resistance value corresponding to the high frequency) / (specific resistance value corresponding to the low frequency) on the basis of the calculated specific resistance value of each of the high and low two frequencies at each survey point, and estimation that a survey point position of the impedance effect > 1 has an underground water vein can be made.

### [Advantageous Effect of Invention]

According to the invention described in claim 1, a detection/check system of an underground water vein and underground water in the underground water vein in which a position of the underground water in the underground water vein can be displayed three-dimensionally at a pinpoint, while the underground water vein in a specific ground area is visualized planarly and two-dimensionally can be realized and provided.

According to the invention described in claim 2, together with a four-dimensional water circulation reproduction/analysis/prediction/visualization simulation system which can visualize an underground water vein in a specific ground area planarly and two-dimensionally, a detection/check system of an underground water vein and underground water in the underground water vein which can three-dimensional display a position of the underground water in the underground water vein at a pinpoint, while the underground water vein in the specific ground area is visualized planarly and two-dimensionally can be realized and provided on the basis of a system configured by including
a large number of electrodes group disposed along a survey line of the specific ground area, a survey point switching unit for executing horizontal exploration and underground vertical exploration of the specific ground area by a specific resistance method, the Wenner method by setting two poles of the electrode with four poles in dipole-dipole arrangement in the electrodes group to potential electrodes and the other two poles to current electrodes and combining and switching them, measuring means for applying a voltage made of high and low two frequencies to the potential electrode with two poles in the dipole-dipole arrangement and making measurement for detecting a current for each of the high and low two frequencies flowing between the potential electrodes by the current electrode with the other two poles at each survey point of the entire specific ground area, specific resistance calculating means for each survey point for calculating a specific resistance value for each of the high and low two frequencies in the horizontal and vertical directions at each survey point in the corresponding specific ground area on the basis of the voltage made of the high and low two frequencies and the current detected for each of the high and low two frequencies, and impedance effect calculating means for each survey point for acquiring an impedance effect at each survey point, made of (specific resistance value corresponding to the high frequency) / (specific resistance value corresponding to the low frequency) on the basis of the calculated specific resistance value of each of the high and low two frequencies at each survey point so that estimation that a survey point position of the impedance effect > 1 has an underground water vein can be made.

According to the invention described in claim 3, a detection/check system of an underground water vein and underground water in the underground water vein that exerts the aforementioned effect can be realized and provided on the basis of such configuration that, in the high and low two frequencies of the voltage used for measurement described in the aforementioned claim 1 or 2, the high frequency is 40 Hz and the low frequency is 4Hz.

### [Brief Description of the Drawings]

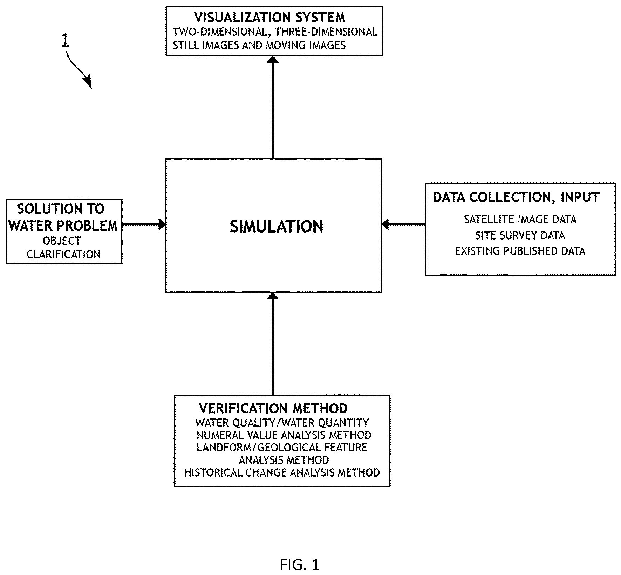

FIG. 1 is a schematic block diagram illustrating a configuration concept of a four-dimensional water circulation reproduction/analysis/prediction/visualization simulation system according to an embodiment.

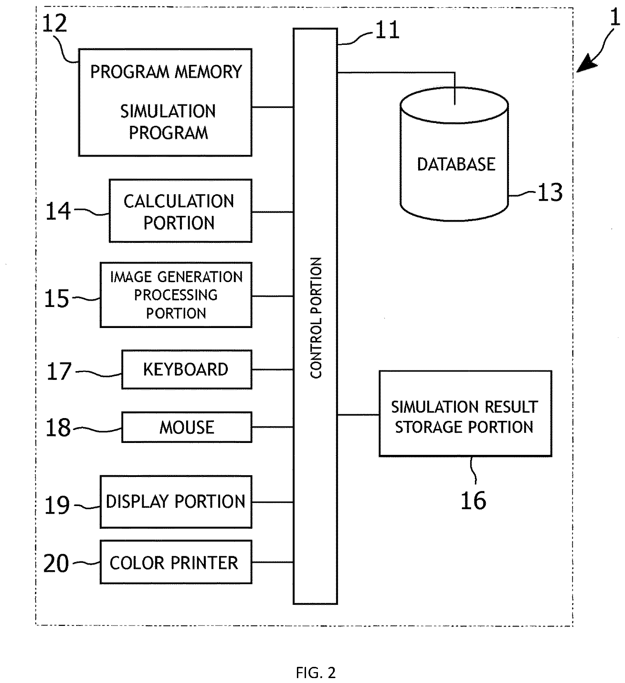

[FIG. 2] FIG. 2 is a schematic block diagram illustrating a configuration of the four-dimensional water circulation reproduction/analysis/prediction/visualization simulation system according to the embodiment.

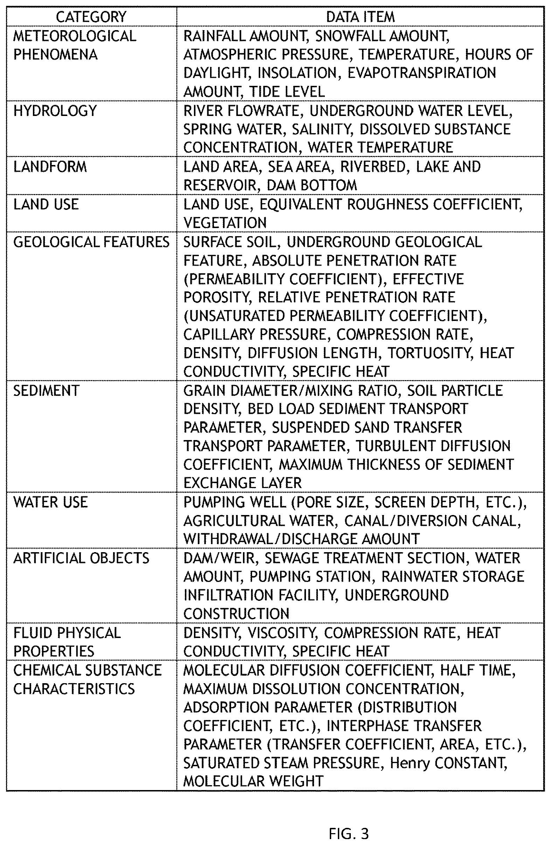

[FIG. 3] FIG. 3 is an explanatory diagram illustrating items of a large quantity of data related to various items such as meteorological phenomena, hydrology, landforms and the like in the four-dimensional water circulation reproduction/analysis/prediction simulation system according to the embodiment.

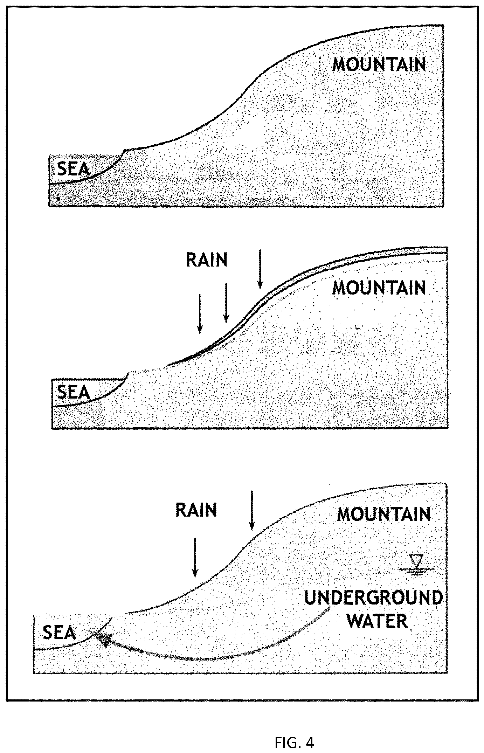

[FIG. 4] FIG. 4 is a conceptual diagram of area initialization processing of a three-dimensional landform model basin water circulation model by simulation execution configuring the four-dimensional water circulation reproduction/analysis/prediction/visualization simulation system according to the embodiment.

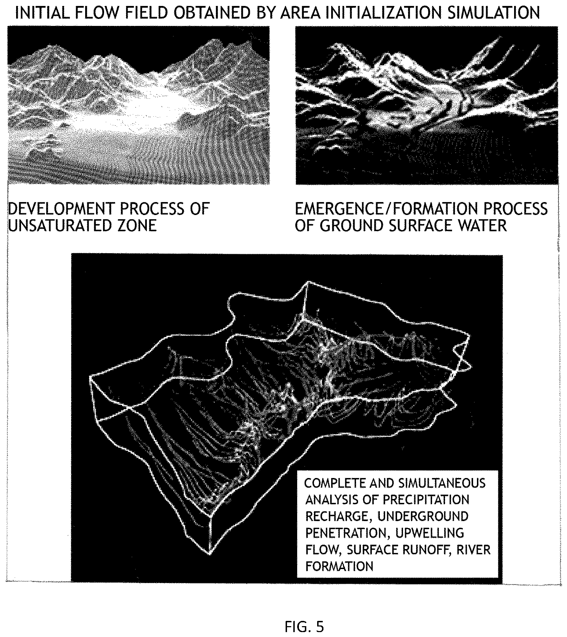

[FIG. 5] FIG. 5 is a conceptual diagram of a development process of an unsaturated zone, an emergence formation process of ground surface water, and a flow-line trajectory of the ground surface and underground obtained by execution of area initialization processing in simulation configuring the four-dimensional water circulation reproduction/analysis/prediction/visualization simulation system according to the embodiment.

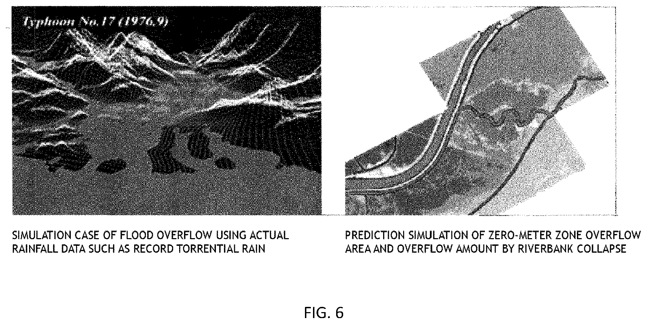

[FIG. 6] FIG. 6 is a schematic diagram illustrating a zero-meter zone overflow area simulation case by flood overflow and river bank collapse using actual rainfall data such as record torrential rain by a flood overflow analysis function of simulation configuring the four-dimensional water circulation reproduction/analysis/prediction/visualization simulation system according to the embodiment.

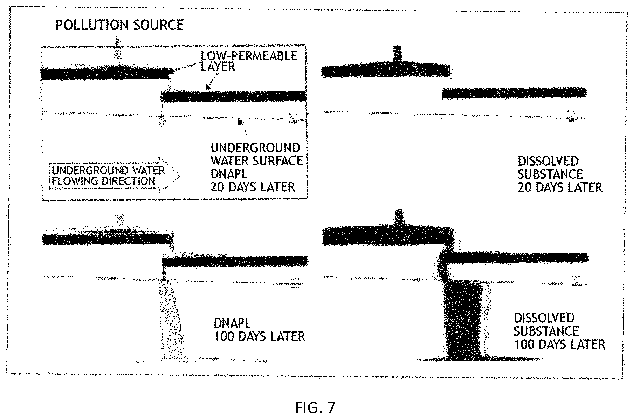

[FIG. 7] FIG. 7 is a schematic diagram illustrating an analysis example of underground penetration of a polluting undiluted solution with a specific weight larger than water in saturated/unsaturated ground by a multiphase flow analysis function of simulation configuring the four-dimensional water circulation reproduction/analysis/prediction/visualization simulation system according to the embodiment.

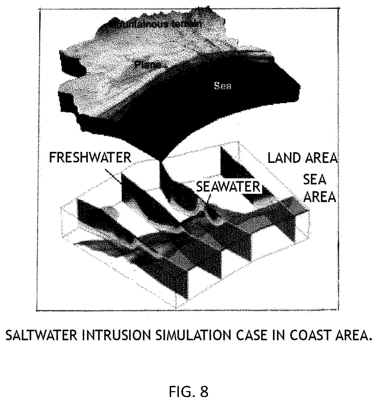

FIG. 8 is a schematic diagram illustrating a saltwater intrusion simulation case on a coast area by a saltwater-freshwater density flow analysis function in simulation configuring the four-dimensional water circulation reproduction/analysis/prediction/visualization simulation system according to the embodiment.

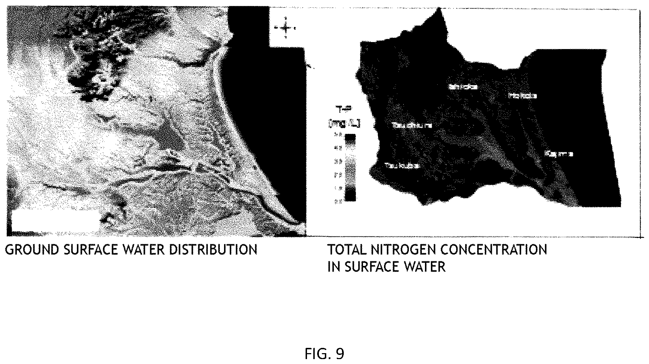

FIG. 9 is a diagram conceptually illustrating a case in which rivers flowing into lakes and marshes and an impact from the basin are analyzed by a reactant transfer analysis function in simulation configuring the four-dimensional water circulation reproduction/analysis/prediction/visualization simulation system according to the embodiment.

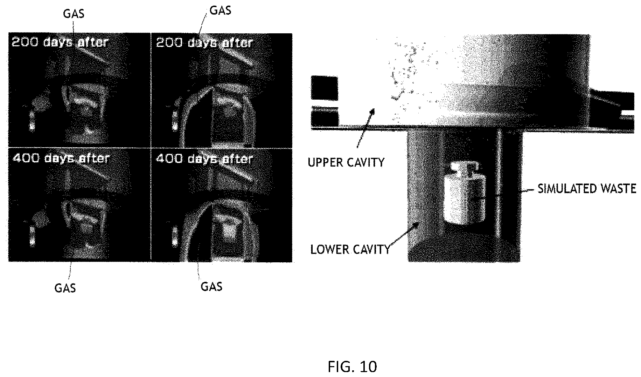

FIG. 10 is a schematic diagram illustrating a three-dimensional simulation case of a gas transport behavior in an artificial barrier in an original position experiment system in a multicomponent gas transport analysis function in simulation configuring the four-dimensional water circulation reproduction/analysis/prediction/visualization simulation system according to the embodiment.

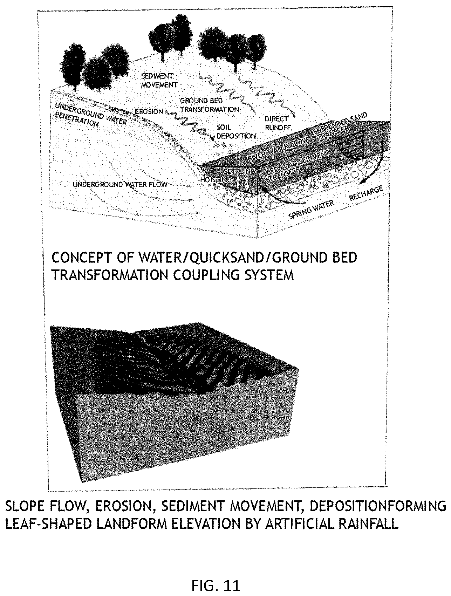

FIG. 11 is a schematic diagram conceptually illustrating concepts of water/quicksand/ground bed transformation coupling system by a water/quicksand coupling analysis function and a slope flow, erosion, sediment movement, a landform undulation forming state with leaf-shaped deposition by artificial precipitation in simulation configuring the four-dimensional water circulation reproduction/analysis/prediction/visualization simulation system according to the embodiment. a

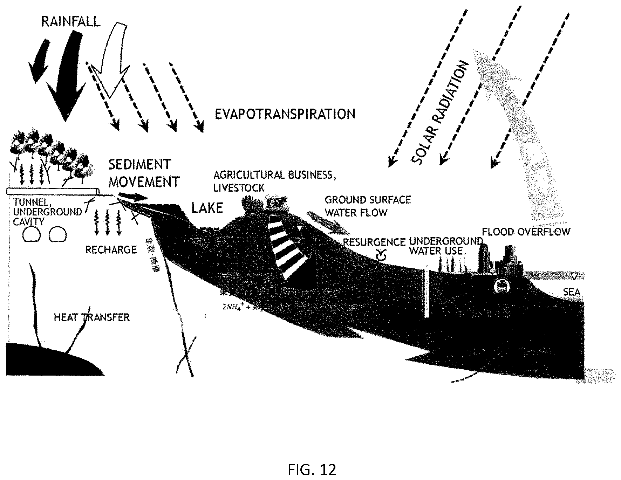

FIG. 12 is an explanatory diagram illustrating a physical concept of a water circulation model of an area intended by a simulation program configuring the four-dimensional water circulation reproduction/analysis/prediction/visualization simulation system according to the embodiment.

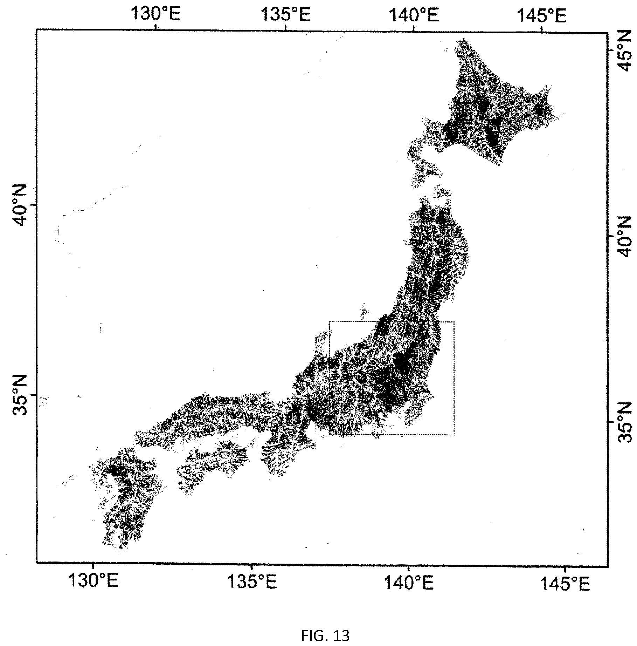

FIG. 13 is a schematic diagram illustrating an original scenery of water circulation in which surface water and underground water integrated in a natural state before artificial intervention was applied in the entire Japan islands analyzed by using a water/air two-phase flow analysis function of simulation configuring the four-dimensional water circulation reproduction/analysis/prediction/visualization simulation system according to the embodiment.

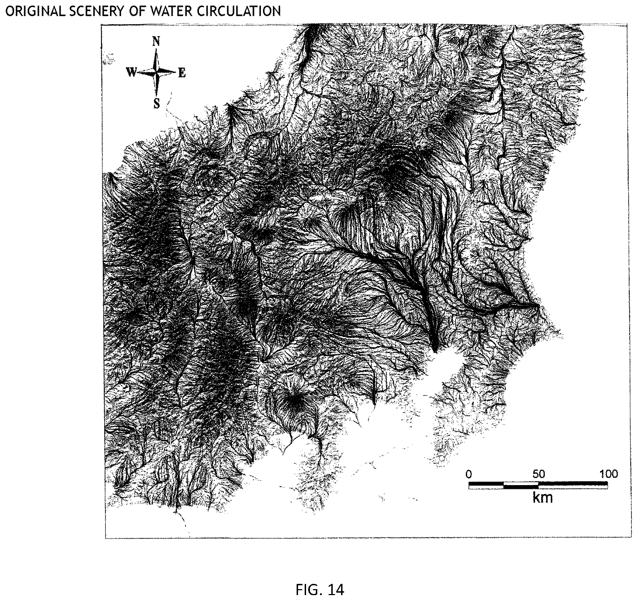

FIG. 14 is a schematic diagram illustrating an original scenery of water circulation in which surface water and underground water integrated in the natural state before artificial intervention was applied in the Kanto region analyzed by using a water/air two-phase flow analysis function of simulation configuring the four-dimensional water circulation reproduction/analysis/prediction/visualization simulation system according to the embodiment.

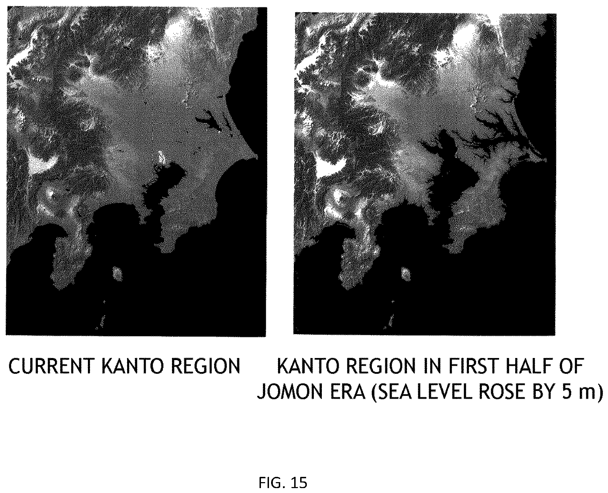

FIG. 15 is a shadow diagram of a landform of the Kanto region at present and in the Jomon era which is 6000 years ago illustrating an example of a historical fact comparison analysis method of simulation analysis verification configuring the four-dimensional water circulation reproduction/analysis/prediction/visualization simulation system.

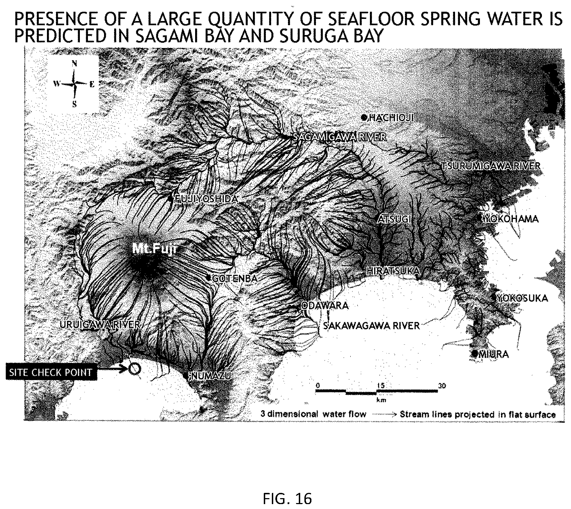

FIG. 16 is a schematic diagram illustrating surface water and underground water in areas of Sagami Bay and Suruga Bay and water circulation in the natural state before artificial intervention such as spring water was applied analyzed by using the water/air two-phase flow analysis function configuring the four-dimensional water circulation reproduction/analysis/prediction/visualization simulation system according to the embodiment.

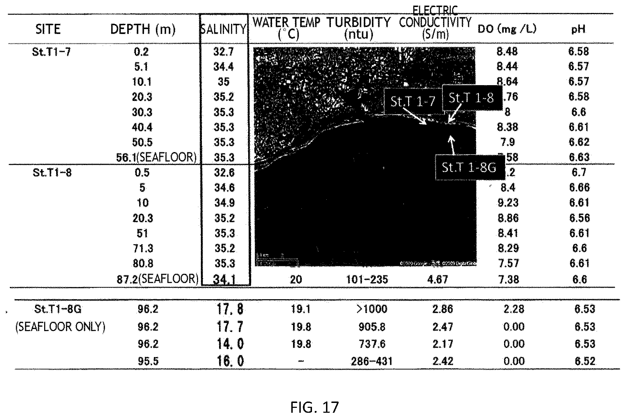

FIG. 17 illustrates an example of a water quality/water quantity numeral value analysis method of verification of simulation analysis configuring the four-dimensional water circulation reproduction/analysis/prediction/visualization simulation system and is an explanatory diagram illustrating water quality analysis data of seawater salinity/water temperature/turbidity/electric conductivity and DO (dissolved oxygen) by sampling seawater in a depth direction at a large number of measurement points in the Suruga Bay coast area.

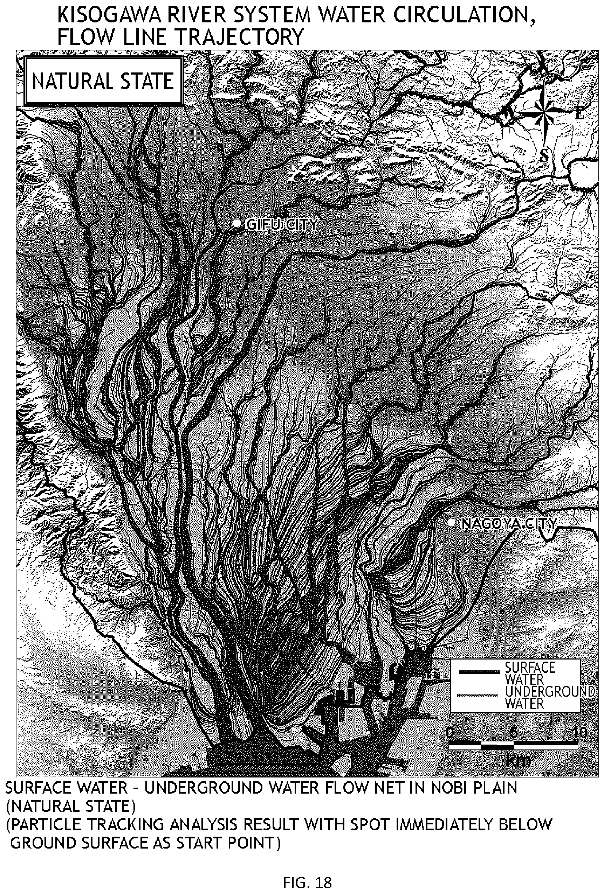

FIG. 18 is a schematic diagram of water circulation of the surface water and the underground water integrated in the natural state in the Nobi Plain before artificial intervention was applied, analyzed by using the water/air two-phase flow analysis function of simulation configuring the four-dimensional water circulation reproduction/analysis/prediction/visualization simulation system according to the embodiment.

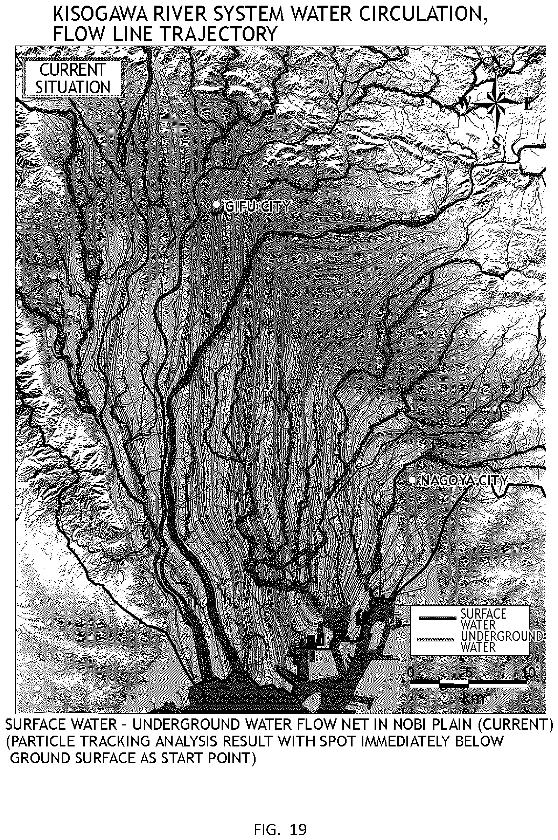

FIG. 19 is a schematic diagram of water circulation of the surface water and the underground water integrated in the Nobi Plain in the 21st century, analyzed by using the water/air two-phase flow analysis function of simulation configuring the four-dimensional water circulation reproduction/analysis/prediction/visualization simulation system according to the embodiment.

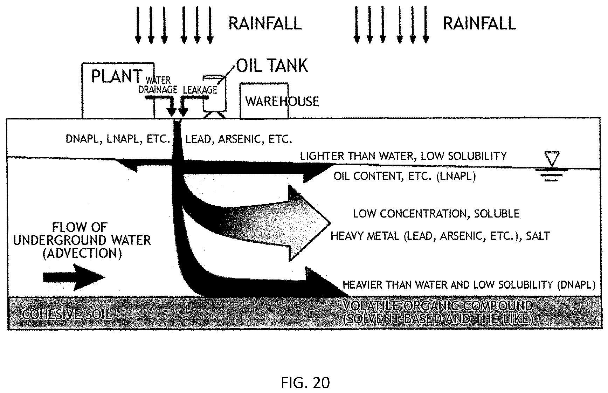

FIG. 20 is a schematic diagram conceptually illustrating a case which simulates a state where an oil content, heavy metal, and thermal soluble substances flow into the underground water from a plant or an oil tank by using a multiphase flow analysis function of simulation configuring the four-dimensional water circulation reproduction/analysis/prediction/visualization simulation system according to the embodiment.

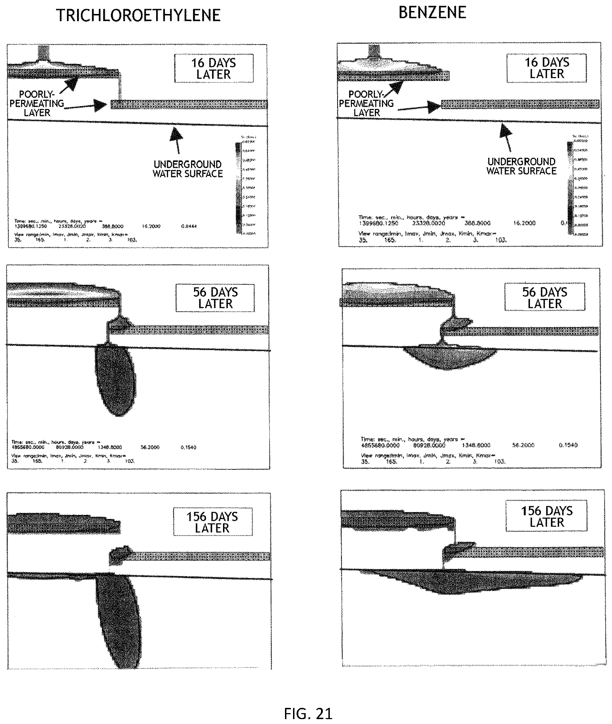

FIG. 21 is a schematic diagram simulating penetration states of trichloroethylene (very insoluble) and benzene (soluble) into an underground water surface from a poorly-permeating layer by using a reactant transfer analysis function of a simulation program configuring the four-dimensional water circulation reproduction/analysis/prediction/visualization simulation system according to the embodiment.

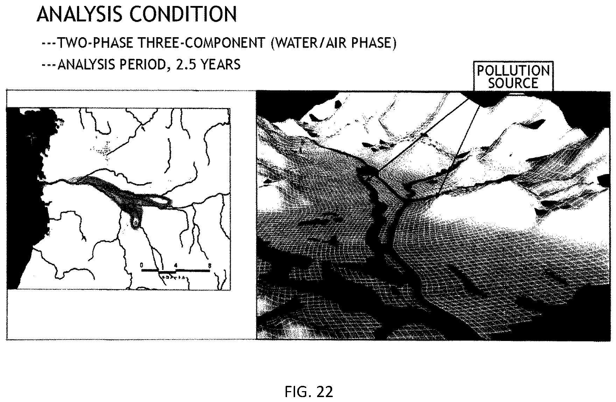

FIG. 22 is a schematic diagram simulating a state of agricultural chemicals pollution from pollution sources at two spots in a certain area analyzed by using the reactant transfer analysis function of simulation configuring the four-dimensional water circulation reproduction/analysis/prediction/visualization simulation system according to the embodiment.

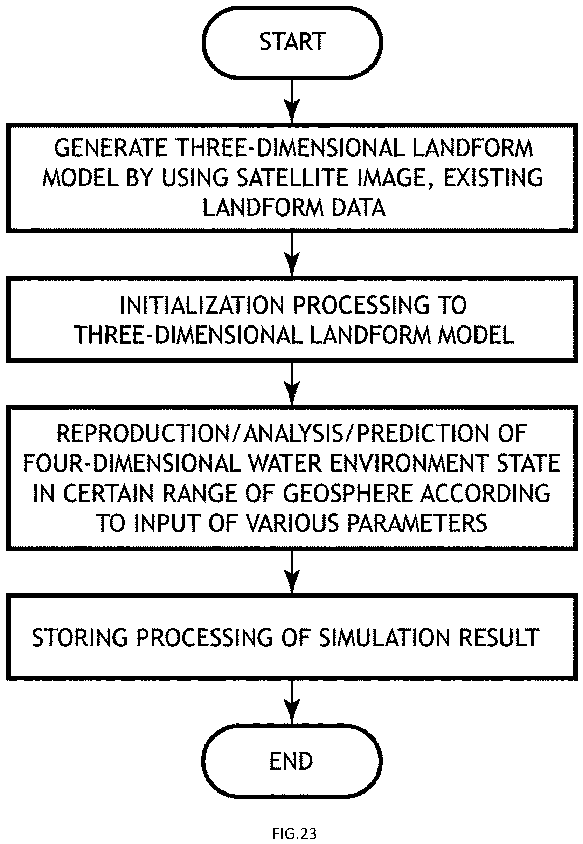

FIG. 23 is a schematic flowchart illustrating a flow of processing of simulation configuring the four-dimensional water circulation reproduction/analysis/prediction/visualization simulation system according to the embodiment.

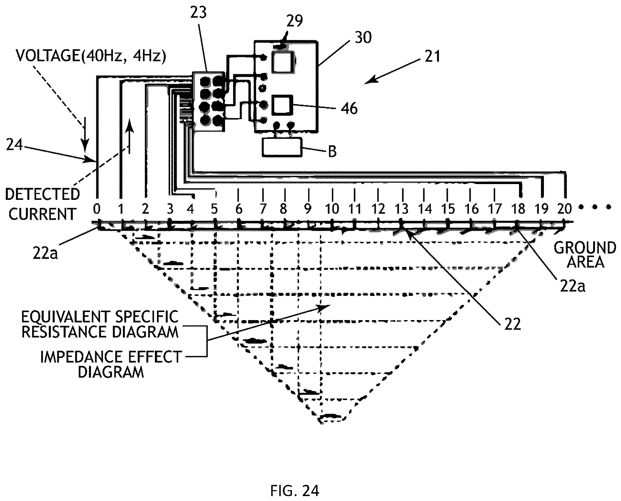

FIG. 24 is a schematic diagram illustrating a concept of entire constitution and a ground exploration result of a detection/check system of underground water in the underground water vein according to the embodiment.

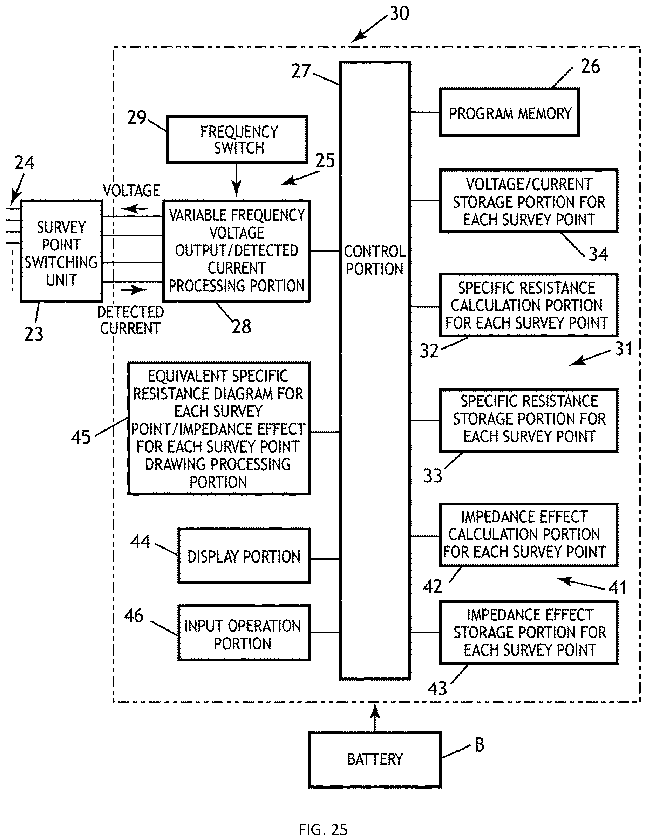

FIG. 25 is a schematic block diagram illustrating the entire constitution of the detection/check system of underground water in the underground water vein according to the embodiment.

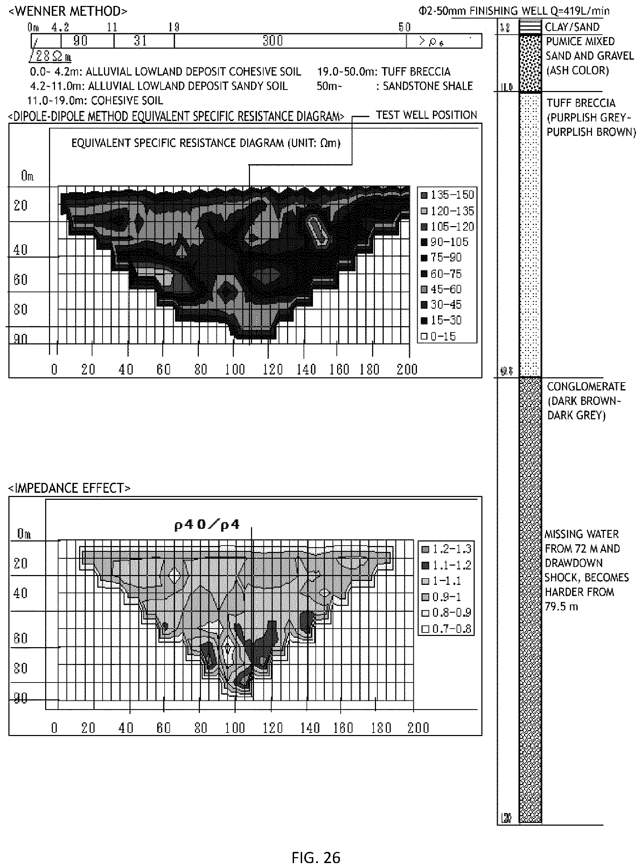

FIG. 26 is a schematic exploration result diagram illustrating an equivalent specific resistance diagram (upper column) by a dipole-dipole method, an impedance effect diagram (lower column), and a distribution diagram (columnar diagram) of rocks corresponding to a depth in Japan; A ground area as an exploration result by the detection/check system, for example, of underground water in the underground water vein according to the embodiment.

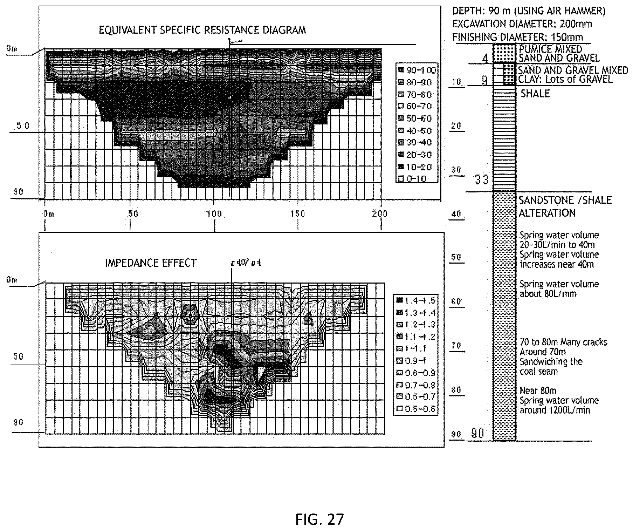

FIG. 27 is a schematic exploration result diagram illustrating the specific resistance value (upper column) by a Wenner method, an equivalent specific resistance diagram by the dipole-dipole method (middle column), the impedance effect diagram (lower column), and the distribution diagram (columnar diagram) of rocks corresponding to a depth in Japan; B ground area, for example, as an exploration result by the detection/check system of underground water in the underground water vein according to the embodiment.

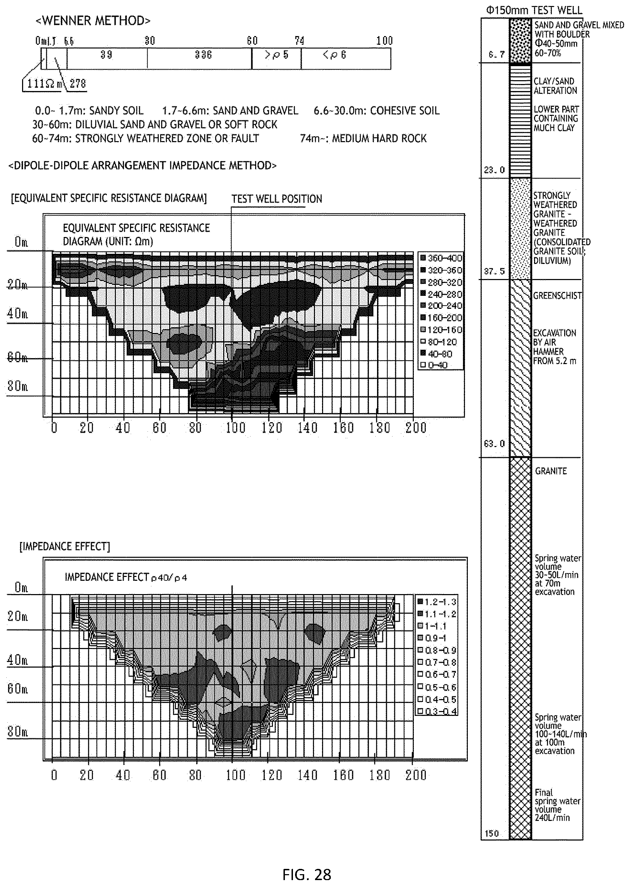

FIG. 28 is a schematic exploration result diagram illustrating the equivalent specific resistance diagram (upper column) by the dipole-dipole method, the impedance effect diagram (lower column), and the distribution diagram (columnar diagram) of rocks corresponding to a depth in Japan; C ground area, for example, as an exploration result by the detection/check system of underground water in the underground water vein according to the embodiment.

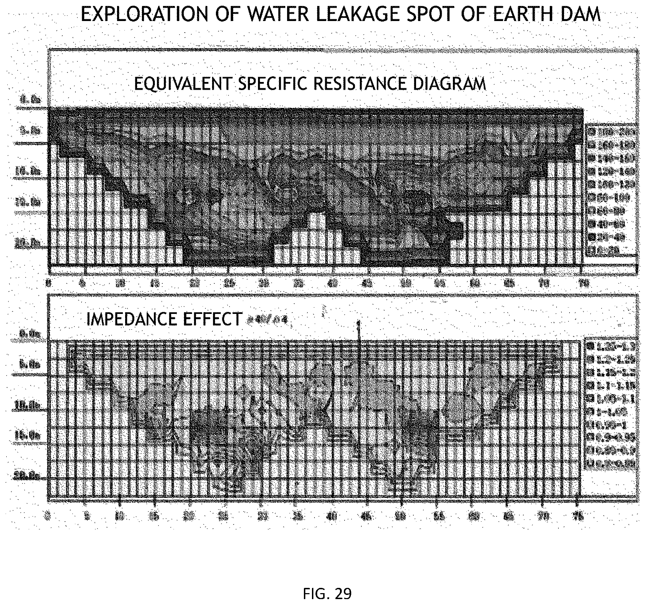

FIG. 29 is a schematic exploration result diagram illustrating the equivalent specific resistance diagram by the dipole-dipole method and the impedance effect diagram as an exploration result of a water leakage spot in an earth dam in Japan; D ground area, for example, by the detection/check system of underground water in the underground water vein according to the embodiment.

### Description of Embodiments

An art for visualizing an underground water vein planarly and two-dimensionally related to a detection/check system of an underground water vein and underground water in the underground water vein in a specific ground area of the present invention is a four-dimensional water circulation reproduction/analysis/prediction/visualization simulation system using a computer for reproducing/analyzing/predicting/visualizing a water circulation state from past to future in a certain range of geosphere range such as a national land and was realized by such configuration that a three-dimensional landform/geological feature model including ground surfaces and underground in a certain range of geosphere generated by using satellite image data, site survey data and existing published landform/geological feature data or either one of satellite image data and site survey data and existing published landform/geological feature data is stored in storage means, an initialization model is generated by executing initialization processing with the underground of the three-dimensional landform/geological feature model set to a saturated zone through execution of a simulation program assembled on the basis of clarification of an analysis object for solving a water problem in demand, simulation is executed by calculation processing by calculating means and image generation processing by image generation processing means in accordance with an input from input means of various parameters related to meteorological phenomena, hydrology, landform, land use, geological features, sediment, water use, artificial objects, fluid physical properties, and chemical substance characteristics for reproduction of past/modern and current times and future prediction on the basis of execution of a simulation program to the initialization model, the simulation result is verified by water quality/water quantity numeral value analysis method, landform/geological feature analysis method, and historical fact comparison method and the like, and the landform/geological feature model and the like are modified as necessary so as to improve simulation accuracy, and the simulation result is stored in in the storage means, they are subjected to two-dimensional or three-dimensional still image and moving image processing and displayed on display means so as to reproduce/analyze/predict/visualize the four-dimensional water circulation state in the certain range of geosphere from the past to the future.

Moreover, the aforementioned art of three-dimensionally displaying the position of the underground water vein in the underground water vein in a specific ground area obtained by visualizing the underground water vein planarly and two-dimensionally so as to enable boring at a pinpoint was realized by configuration having a large number of electrodes group disposed along a survey line of a specific ground area, a survey point switching unit for executing horizontal exploration and underground vertical exploration of the specific ground area by a specific resistance method, a Wenner method by setting two poles of the electrode with four poles in dipole-dipole arrangement in the electrodes group to potential electrodes and the other two poles to current electrodes and combining and switching the electrodes, measuring means for applying a voltage made of high and low two frequencies to the potential electrode with two poles in the dipole-dipole arrangement and making measurement for detecting a current for each of the high and low two frequencies flowing between the potential electrodes by the current electrode with the other two poles at each survey point of the entire specific ground area, specific resistance calculating means for each survey point for calculating a specific resistance value for each of the high and low two frequencies in the horizontal and vertical directions at each survey point in the corresponding specific ground area on the basis of the voltage made of the high and low two frequencies and the current detected for each of the high and low two frequencies, and
impedance effect calculating means for acquiring an impedance effect at each survey point, made of (specific resistance value corresponding to the high frequency) / (specific resistance value corresponding to the low frequency) on the basis of the calculated specific resistance values of each of the high and low two frequencies at each survey point so that estimation that a survey point position of the impedance effect > 1 has an underground water vein can be made.

### Embodiment

Hereinafter, first, an "art for visualizing an underground water vein planarly and two-dimensionally" for realizing a detection/check system 21 of an underground water vein and underground water in the underground water vein in a specific ground area according to an embodiment will be described in detail by referring to the drawings.

Later, an "art of displaying a position of underground water in an underground water vein visualized planarly and two-dimensionally so as to enable boring at a pinpoint" for realizing the detection/check system 21 of an underground water vein and underground water in the underground water vein in a specific ground area according to the embodiment will be described in detail.

Hereinafter, a four-dimensional water circulation reproduction/analysis/prediction/visualization simulation system which is the art for visualizing an underground water vein planarly and two-dimensionally for realizing a detection/check system 21 of an underground water vein and underground water in the underground water vein according to the embodiment of the present invention will be described in detail.

That is, regarding the four-dimensional water circulation reproduction/analysis/prediction/visualization simulation system according to this embodiment, as illustrated in FIG. 1, in four-dimensional water circulation reproduction/analysis/prediction simulation(hereinafter referred to as "simulation") configuring the four-dimensional water circulation reproduction/analysis/prediction/visualization simulation system, a simulation program is assembled on the basis of clarification for solving a water problem demanding the simulation, as data required for the simulation, a large volume of data configured by satellite image data, site survey data, existing published data (or either one of the satellite image data and the site survey data and the existing published landform/geological feature data may be used) and the like is collected and input, the simulation result is verified by a water quality/water quantity numeral value analysis method, a landform/geological feature analysis method, and a historical fact comparison method and the like, and in a case of discrepancy between the actual and the analysis result, the landform/geological feature model and the like in the simulation program are modified so that accurate reproduction of the water circulation of a target area is realized.

Moreover, the simulation analysis result is processed into two-dimensional or three-dimensional still images and moving images, and visualization of the water circulation of the analysis target area including the underground water which has not been seen by humans so far is realized.

The simulation configuring the four-dimensional water circulation reproduction/analysis/prediction/visualization simulation system has, as illustrated in FIG. 2, a program memory 12 storing the four-dimensional water circulation reproduction/analysis/prediction simulation program (hereinafter, referred to as the "simulation program"), a control portion 11 for controlling the entire body and for controlling various types of processing on the basis of the simulation program, a database 13 for collecting/accumulating various data required for the four-dimensional water circulation reproduction/analysis/prediction processing, a calculation portion 14 for executing various calculations required for the four-dimensional water circulation reproduction/analysis/prediction processing on the basis of the simulation program, an image generation processing portion 15 for executing image generation processing in accordance with simulation processing on the basis of the simulation program, a simulation result storage portion 16 for storing a simulation result on the basis of the simulation program, a keyboard 17 for data input, a mouse 18, a color printer 19 for data output, and a display portion 20.

The database 13 collects/accumulates a large quantity of data related to various data items such as meteorological phenomena, hydrology, landforms and the like as illustrated in FIG. 3 in order to execute the four-dimensional water circulation reproduction/analysis/prediction processing. The data includes data related to meteorological phenomena, hydrology and the like related to a distant past to modern and current times and further to future prediction.

In this case, the large quantity of data related to the various items can be collected/accumulated from satellite image data, actual site survey data, external databases such as published existing hydrological water quality database, meteorological database and the like and publicly-known documents such as Chronological Scientific Tables and the like.

Subsequently, a function related to the four-dimensional water circulation reproduction/analysis/prediction processing in the simulation program will be described in detail.

The simulation program employs GETFLOWS (General purpose Terrestrial fluid-FLOW Simulator: registered trademark) provided by Professor TOSAKA Hiroyuki, Tokyo University, Geosphere Environmental Technology Corp.

This GETFLOWS is a base art configuring the four-dimensional water circulation reproduction/analysis/prediction/visualization processing according to this embodiment and has been technologically established.

The simulation program is a program for executing geosphere fluid modeling and numeral value simulation and is characterized by a point that a water circulation system in a land area is formulized as a multiphase multicomponent fluid system and flows of water on the ground and underground which has been difficult were integrated.

That is, general underground water analysis, river runoff analysis, flood/overflow analysis, interaction analysis of ground surface water/underground water, advection diffusion analysis including pollutant, oil stratum analysis, heat analysis and the like are executed.

The simulation program has, as major elements, a water/air two-phase flow analysis function expressing a flow of water in a land water system by air/water two-phase flow simulation including ground surface water, a flood overflow analysis function for analyzing ground surface water flow involving a flood overflow by torrential rain and dike break, a multiphase flow analysis function for analyzing a water phase, an air phase, and a polluting undiluted solution phase on the ground/underground, a water/heat coupling analysis function for analyzing heat advection by a fluid phase (water/gas phase) and heat conduction in a solid phase such as soil/rock ground, a saltwater-freshwater density flow analysis function for analyzing a fluid behavior, considering an interaction (density flow) of freshwater and seawater in a coast area, a reactant transfer analysis function simulating a polluting substance generated in a basin and a substance transfer process on and under the ground, a reactant transfer analysis function, a multicomponent gas transport analysis function for analyzing a transfer behavior in the underground rock of gas generated from radioactive wastes/wastes such as general garbage and the like and gas leaking from a buried pipe, and water/quicksand coupling analysis function for analyzing a spatial and long-term change in a recharging function of underground water in an intermountain area or underground water in a water source.

A flow of the basic processing of the four-dimensional water circulation reproduction/analysis/prediction/visualization simulation system is configured such that, as illustrated in FIG. 23, a three-dimensional landform/geological feature model including the ground surface and underground in a certain area of geosphere is generated by operations of the calculation portion 14 and the image generation processing portion 15 by using the satellite image and existing landform data accumulated in the database 13 and is stored in the database 13 and then, an initialization model is generated by executing the initialization processing with the underground of the three-dimensional landform/geological feature model set to a saturated zone by the simulation program and is stored in the simulation result storage portion 16, the reproduction/analysis/prediction are performed by the image and numeral values of the four-dimensional water circulation state from the past to the future in the certain range of geosphere by the operations of the calculation portion 14 and the image generation processing portion 15 in response to an input from the keyboard 17 and the like of the various parameters related to meteorological phenomena, hydrology, landforms, land use, geological feature, sediment, water use, artificial objects, fluid physical properties, and chemical substance characteristics for reproduction of the past/modern and current times and future prediction to the initialization model and are stored in the simulation result storage portion 16, displayed on the display portion 20 as necessary, and are output for print by the color printer 19.

The functions included in the simulation program will be described below in detail.

### <Water/air two-phase flow analysis function>

This function expresses the flow of water in the land water system in detail by the water/air two-phase flow simulation including the ground surface water. Moreover, an initial state of fluid distribution in the land water system is reproduced by area initialization, and various phenomena occurring there are analyzed.

Complicated spatial expressions such as landforms/geological features, meandering river channel/riverbed landforms, artificial objects and the like in the water/air two-phase flow analysis function can be modelled flexibly by a hexahedral grid of arbitrary geometry called corner-point type differential grid.

Moreover, since physical property data can be given to each grid or each grid surface of the landform/geological feature model, expressions of a tunnel wall surface, a sheet, a wall-state artificial structure, an anisotropic ground and the like can be made easily.

Application fields of the water/air two-phase flow analysis function include mutual action analysis of ground surface water/underground water (drying up of rivers, spring water/recharge, maintenance flow evaluation of river, optimization of water resource use plans and the like), river runoff analysis, saturated/unsaturated seepage analysis, environmental impact evaluation by construction works of tunnels, dams, antiflood ponds, underground structures and the like, prediction of water resource abundance, optimization of water pumping plans and the like.

An upper column in FIG. 4 illustrates a conceptual diagram of the area initialization processing of the three-dimensional landform model.

As illustrated in a middle column in FIG. 4, calculation is started by inputting a certain amount of rainfall (1 to 2 mm/day which is the same as the underground water recharge amount). As a result, a state where air and water intrude into the ground surface, and saltwater heavier than water is pushed out to the sea or river little by little can be obtained.

As illustrated in a lower column in FIG. 4, water distribution of saltwater, underground water level, river flowrate and the like at substantially the same degree as the present can be calculated by calculation for several tens of thousand years. And a state where rainfall, the underground water level, and underground water outflow are balanced can be obtained. As above, preparation for executing the calculation using the actual rainfall amount data is completed.

Subsequently, the area initialization simulation is executed so as to prepare grids of landform/geological features and the like, hydraulic parameters such as water permeability coefficient and the like are set to the grid, and the calculation is started. First, the grid of the basin water circulation model is filled with saltwater (initial condition).

FIG. 5 illustrates a development process of an unsaturated zone, an emergence formation process of ground surface water, and a flow-line trajectory conceptual diagram of the ground surface and underground obtained by the area initialization simulation.

### Flood overflow analysis function

This function is a function for simulating a ground surface water flow involving a flood overflow by torrential rain and dike break.

The simulation program analyzes the ground surface flow by diffusion wave approximation omitting an inertial term and a speed term in a motion equation so that large movement of water to various patterns of torrential rain and dike break conditions can be followed stably and at a high speed.

Prediction of an overflow area and an overflow water amount of rivers makes a tool supporting preparation of water drainage design in cities and evacuation plans at a disaster.

Moreover, since the underground water (including air) in the ground is solved at the same time, rapid rise in the underground water level and inland overflow at the torrential rain are expressed, and a spot of occurrence, a submergence area/submergence amount thereof can be predicted.

The numeral value information obtained by the simulation includes an overflow range, a water amount, a pressure, potential, a water depth, a water level, a flow velocity and the like.

FIG. 6 illustrates a conceptual diagram of a case of zero-meter zone overflow area simulation by flood overflow and river bank collapse using actual rainfall data such as record torrential rain.

Application fields of the flood/overflow analysis can include submergence area prediction at torrential rain, inland overflow, overflow area prediction after riverbank collapse, prediction of waterlogging damage area in low and flat agricultural lands, examination of effects of drainage measures such as a closed conduit, pump and the like, prediction of a submergence range of a high-tide overflow in a coast area and inland overflow by record torrential rain and the like as examples.

### Multiphase flow analysis function

This function is to analyze a multiphase simultaneous flow of a water phase, an air phase, a polluting undiluted solution phase (Non-Aqueous Phase Liquid: NAPL) on the ground and in the underground by a three-dimensional solver at a practical level.

The polluting undiluted solution phase has organic solvents and hydrocarbon-based non water-soluble fluids as targets and can give fluid substances (specific weight, viscosity factor and the like) of each substance in detail.

The ease to move (Mobility) of the NAPL phase in the ground gives a three-phase flow parameter (relative penetration curve) of Stone (1970, 1973) and Parker (1987) et al. which is generally known by an oil stratum simulation and can follow a mutually replacing behavior of the fluid phase.

Moreover, volatilization/dissolution (interphase transfer) generated by contact of the NAPL phase with the air and the underground water in the unsaturated zone or substance transfer in the unsaturated zone or in the water phase can be considered at the same time.

Numeral value information obtained by the simulation is polluting substance concentration in the underground water phase, polluting substance concentration in the gas phase, saturation of the water phase/gas phase/NAPL phase, a pressure, potential, water depth/water level, a flow velocity and the like.

FIG. 7 illustrates an analysis example of underground penetration of a polluting undiluted solution (DNAPL) with a specific weight larger than that of water in saturated/unsaturated grounds. This is a conceptual diagram of a simulation case of 20 days later and 100 days later with a multiphase multicomponent system as a target, considering dissolution from the polluting undiluted solution phase to the underground water phase and an advection diffusion process.

Application fields of the multiphase flow analysis include prediction of a pollution range change at underground water/soil pollution sites by heavy metal, NAPL and the like, examination and selection of effects of various measures (water pumping, barrier well, water-stop wall, air-sparging, soil gas suctioning, bioremediation and the like), behavior prediction/risk assessment of leaking harmful substances in rivers and waterfront environments, various design analysis/environmental impact prediction in underground energy storage facilities for oil/LPG and the like.

### Saltwater-freshwater density flow analysis function

This function simulates a fluid behavior considering a mutual action (density flow) of freshwater and sea water in a coast area.

The simulation program usually models both a land area and a sea area and directly incorporates a seafloor topography continuing to the land area landform in the sea area. Then, the seawater is expressed as ground surface water containing a salt content and is solved simultaneously with the underground water on the sea floor.

Without discriminating the ground surface water and the underground water, a freshwater-seawater transition zone formed in the coast area and a density flow generated around it can be analyzed by a difference in a salt content contained in the water phase in both of them.

Moreover, by considering a dynamic change in an ocean level by a sea tide and ocean level fluctuation, the underground physical property distribution can be identified by analyzing an influence zone generated in the land area and distance attenuation of water level response.

In water resource development in the coast area, evaluation of proper pumping amount and the like by considering various water quality standards are made by reproducing/predicting drawing of seawater by a well and a salinity change in the pumping. The numeral value information obtained by the simulation includes salinity, saturation in water phase/gas phase, a pressure, potential, a water depth/water level, a flow velocity and the like.

The application fields of the freshwater-seawater density flow analysis include a density flow problem involving a freshwater-seawater transition zone, sea tide/ocean level change transformation analysis, water environmental impact evaluation for construction of an underground dam in a coast area, isolated-island freshwater lens water resource amount prediction and the like.

FIG. 8 illustrates a conceptual diagram of a saltwater intrusion simulation case in a coast area.

This analyzes saltwater-freshwater transition zone balanced with natural conditions such as a landform, a stratum distribution, precipitation, ocean level change and the like.

### Reactant transition analysis function

This function simulates a pollutant generated in a basin and substance movement process on the ground and underground in detail.

Occurrence of a polluting load is diversified and is related to living drainage and business drainage in a city area, fertilization to agricultural lands, feces and urine of stocks and the like.

Decomposition/reaction processes, intrusion paths to the underground, and movement forms after that are diversified depending on differences in generation source and a polluting substance.

The simulation program realizes and provides a more natural physical model incorporating river transportation, intrusion into the ground, substance transfer processes of sorption/desorption, advection diffusion and the like while considering kinetic changes of the substance by decomposition/chemical reactions for various polluting substances from a point source and a non-specific emission source.

As a result, a clue can be obtained to knowledge on a detailed mechanism of a delay phenomenon and other substance movement processes which have been difficult with a primary unit method which forcedly gives a polluting load amount from a conventional macroscopic viewpoint.

The numeral value information obtained by the simulation includes concentration of each substance in water, concentration in a solid phase, saturation in a water phase/gas phase, a pressure, potential, a water depth/water level, a flow velocity and the like.

The application fields of the reactant transfer analysis include nitrate nitrogen pollution, prediction of a polluting load amount to a closed water area, stratum disposal system performance evaluation of radioactive wastes (nuclide migration/exposed dose evaluation) and the like.

FIG. 9 illustrates a conceptual diagram of a case in which an impact from a river flowing into lakes and a basin thereof are analyzed by the simulation.

### Multicomponent gas transport analysis function

This function simulates a movement behavior of gas generated from radioactive wastes/wastes such as general garbage and gas leaking from a buried pipe in the underground in detail.

The gas movement in the ground is described by generalization Darcy's rule similarly to the water-air two-phase flow simulation, and analysis considering a dynamic change in pressure dependence of penetration parameters such as dissolution/release generated with accumulation/rise of a void pressure, void deformation of a medium, an increase in the penetration rate and the like can be made.

Moreover, detailed analysis according to a field condition and a test system such that a substance component (odorant, tracer) contained in the gas phase moves with various phase changes and adsorption/desorption and the like can be made.

The numeral value information obtained by the simulation is saturation of the water phase/gas phase, substance concentration in the water phase/gas phase, a pressure, potential, a water depth/water level, a flow velocity and the like.

The application fields of the multicomponent gas transport analysis include leakage gas diffusion movement from a damage portion in a buried pipe, a transfer behavior of the gas caused by radioactive wastes and metal container erosion, CO2 injection/dissolution in underground disposal of carbon dioxide, containment performance analysis by cap lock and the like.

FIG. 10 illustrates a conceptual diagram of a three-dimensional simulation case of the gas transfer behavior in an artificial barrier in an in-situ experiment system.

It conceptually illustrates a state of following/reproducing a process in which a gas generated from a simulated waste is dissolved/moved in the void water.

### Water/quicksand coupling analysis function

This function analyzes a spatial and long-term change in the underground water recharging function in underground water in an intermountain area or in a water source by coupling a flow model integrating the ground surface water and the underground water and a quicksand transport model.

Conceivable hydrological elementary processes are ground surface water, underground water flow, ground surface water/underground water mutual action (river influence, spring water and the like), bed load sediment movement, suspended sand movement (advection and turbulent diffusion), settling/hoisting, landform change (erosion/deposition) by sediment movement, and a flow regime change caused by a landform change.

FIG. 11 conceptually illustrates a concept of water/quicksand/ground bed transformation coupling system and slope flow, erosion, sediment movement, a landform undulation forming state with leaf-shaped deposition by artificial precipitation.

The numeral value information obtained by the simulation program includes saturation for each fluid phase (water phase/gas phase), a pressure, potential, a flow velocity, a landform elevation, suspended sand concentration, sediment flux and the like.

The application fields of the water/quicksand coupling analysis include analysis of a landform change by a water flow, erosion control of an intermountain water source area, integrated water resources management (IWRM: Integrated Water Resources Management), preparation of comprehensive sediment control plans and the like.

FIG. 12 illustrates a physical concept of the water circulation model of an area which is a target of the simulation program.

Subsequently, a specific application example of the four-dimensional water circulation reproduction/analysis/prediction/visualization simulation system will be explained.

FIG. 13 illustrates a water circulation model of the entire Japan islands and captures a rough structure of land area/coast water circulation. This is a result of simulation by a three-dimensional model obtained by planarly dividing the land area and the coast ocean part into a grid of a 1 km order and by inputting landforms and rough states of geological features.

A grid system calculation of this scale is intended for national schematic evaluation of entire Japan, for example, such as structure estimation of a flow system on the ground surface and the underground by a large landform, water resource amount evaluation of a wide area, prediction of a change in the underground water freshwater resource amount by global warming, latent hydraulic power generation potential and the like.

Moreover, a seafloor landform is reflected in this mode, a saltwater condition of the sea area is reflected, and a resurgence state of underground water on the coast seafloor around the land area can be also expressed.

FIG. 14 illustrates a three-dimensional trajectory of water droplets by rainfall penetrate and gush out of the ground surface as an orthogonal projection when seen from the sky by making a long-term equilibrium calculation on a central part of Japan islands around the Kanto region by using the water/air two-phase flow analysis function of the simulation configuring the four-dimensional water circulation reproduction/analysis/prediction/visualization simulation system and by calculating a flow velocity field from the obtained pressure distribution and saturation rate distribution.

This FIG. 14 illustrates an original scenery of the water circulation of the Tone River before artificial intervention was applied, and the flows of the surface water and underground water of the Tone River go toward Tokyo Bay, not to Choshi in Chiba Prefecture, for example.

The left figure in FIG. 15 is a shadow diagram illustrating the landform of the current Kanto region, while the right figure is a shadow diagram illustrating the landform of the Kanto region 6000 years ago. The first half of the Jomon era 6000 years ago was the Jomon transgression era when the sea level rose approximately by 5 m, and the right figure in FIG. 15 has the sea level in the left figure rose by 5 m by a computer, and it clearly expresses that the sea intruded deeply into the Kanto region in the Jomon era. The land continues in the neighborhood of current Sekijuku at a tip end of the intrusion of the sea into the Kanto Plain, and it is clear that the Tone River changes its flow direction to the south and flows into Tokyo Bay.

By means of such historical fact comparison verification method, the result of the aforementioned simulation analysis can be verified to illustrate the original scenery of the water circulation in the Kanto region before artificial intervention was applied, and the four-dimensional water circulation reproduction/analysis/prediction/visualization simulation system can provide objective and accurate water circulation to the society.

FIG. 16 is a result of water circulation of surface water and underground water integrated in areas of Sagami Bay and Suruga Bay analyzed by using the water/air two-phase flow analysis function of the simulation configuring the four-dimensional water circulation reproduction/analysis/prediction/visualization simulation system according to this embodiment. Such a result of analysis is illustrated that the precipitation droplets input into the ground surface penetrate into the underground and become a large quantity of the seafloor spring water in the Sagami Bay and the Suruga Bay.

FIG. 17 illustrates measurement data of seawater salinity/water temperature/turbidity/electric conductivity and DO (dissolved oxygen) by sampling seawater in a depth direction at a large number of measurement points in the Suruga Bay coast area for verification of accuracy of the simulation analysis result conducted by Professor Kenji Kato at Shizuoka University. At a St. T1-8G measurement point in this water quality analysis result, the salinity of the seawater at a seafloor 96 m point was confirmed to be close to freshwater, and a numeral value of its DO at zero was further obtained. It illustrates that oxygen contained in the water was ingested by bacteria and became zero while the underground water from Mt. Fuji deeply entered into Suruga Bay and slowly flowed down to the sea.

By means of the water quality/water quantity analysis method with the numeral values, it can be verified that the underground water analysis result of the aforementioned simulation was correct, and the four-dimensional water circulation reproduction/analysis/prediction/visualization simulation system can provide an objective and accurate state of the water circulation to the society.

The water quality/water quantity analysis method with the aforementioned numeral values is one of verification analysis methods configuring the four-dimensional water circulation reproduction/analysis/prediction/visualization simulation system according to this embodiment.

FIG. 18 is an analysis result of the water circulation of the surface water and underground water integrated in a natural state in the Nobi Plain before the artificial intervention was applied, analyzed by using the water/air two-phase flow analysis function of the simulation configuring the four-dimensional water circulation reproduction/analysis/prediction/visualization simulation system.

In the natural state of the Nobi Plain in Japan, for example, the analysis result was such that the surface water flowed like a fine mesh on the ground surface, and the entire area was a wetland, and it becomes obvious also from this result that the lifestyle of people in the Nobi Plain several hundred years ago was a ring levee that houses were surrounded by levees.

FIG. 19 is an analysis result of the water circulation of the current surface water and underground water integrated in the 21st century in the Nobi Plain, for example, analyzed by using the water/air two-phase flow analysis function of the simulation configuring the four-dimensional water circulation reproduction/analysis/prediction/visualization simulation system according to this embodiment. An analysis result tells that artificial levees were constructed from the early modern to the modern times, the river of the surface water was pushed into the levee, and the underground water flows below them with high density.

Comparison between FIG. 18 with FIG. 19 shows that human living for several hundred years has altered the natural water circulation, and it clearly verifies that the four-dimensional water circulation reproduction/analysis/prediction/visualization simulation system reproduces the long-term historical phenomena.

FIG. 20 conceptually illustrates a case of analysis of a state in which an oil content, heavy metal, and thermal soluble substances flow into the underground water from a plant or an oil tank by using a multiphase flow analysis function of the simulation configuring the four-dimensional water circulation reproduction/analysis/prediction/visualization simulation system.

FIG. 21 is a conceptual diagram of a case of analysis simulation of penetration states of trichloroethylene (very insoluble) and benzene (soluble) into an underground water surface from a poorly-permeating layer by using a reactant transfer analysis function of the simulation configuring the four-dimensional water circulation reproduction/analysis/prediction/visualization simulation system according to the embodiment.

FIG. 22 is a conceptual diagram of a case of analysis simulation of a state of agricultural chemicals pollution from pollution sources at two spots in a certain area also by using the reactant transfer analysis function of the simulation configuring the four-dimensional water circulation reproduction/analysis/prediction/visualization simulation system.

According to the four-dimensional water circulation reproduction/analysis/prediction/visualization simulation system described above, reproduction of the water circulation (surface water/underground water, seawater) in the natural state specific to the area in the past, analysis and estimation of a state of current water circulation (surface water/underground water, seawater) and a state of circulation of urban water drainage, agricultural water, chemicals and the like, and prediction/estimation and visualization of the water circulation (surface water/underground water, seawater) state in the future can be made.

As a result, such extremely unconventional effects are exerted that practical and objective four-dimensional water circulation reproduction/analysis/prediction/visualization system which can integrally grasp, reproduce, analyze, predict, and visualize the flows of water on the ground and underground requested in various water problems (water resources, water environment, water disasters) occurring in land areas in a certain region in the national land can be realized and provided.

Each art element configuring the four-dimensional water circulation reproduction/analysis/prediction/visualization simulation system according to this embodiment has been already established specifically, and it is needless to say that the four-dimensional water circulation reproduction/analysis/prediction/visualization simulation system according to this embodiment can be specifically realized by a computer.

As described above, according to the four-dimensional water circulation reproduction/analysis/prediction/visualization simulation system of this embodiment, the underground water vein can be visualized planarly and two-dimensionally in order to realize the detection/check system 21 of the underground water vein and the underground water in the underground water vein according to the present invention.

That is, by storing a three-dimensional landform/geological feature model including ground surfaces and underground in a certain range of geosphere generated by using satellite image data, site survey data and existing published landform/geological feature data or either one of satellite image data and site survey data and existing published landform/geological feature data in storage means, and by executing the simulation program incorporated in a computer on the basis of clarification of an analysis object for solution of the water problem in demand, it becomes possible to reproduce the water circulation (surface water/underground water, seawater) in the natural state unique to the area in the past, to analyze and estimate the water circulation (surface water/underground water, seawater) state at the present, urban water drainage, agricultural water, seawater desalination, a state of the water circulation such as chemical substances and the like, and to predict and estimate the water circulation (surface water/underground water, seawater) state in the future, and by visualizing these analysis results, an underground water vein can be visualized planarly and two-dimensionally in order to realize the detection/check system 21 of an underground water vein and underground water in the underground water vein according to the present invention.

Hereinafter, the art of three-dimensionally displaying a position of the underground water in the underground water vein in the specific ground area visualized planarly and two-dimensionally according to the embodiment so as to enable boring at a pinpoint will be described in detail by referring to the drawings.

First, the specific resistance method of the dipole-dipole arrangement employed for the exploration of the underground water vein will be described in brief.

In general, in the specific resistance method, a work for acquiring the specific resistance at each survey point is executed by installing a large number of electrodes along the survey line in advance, by combining four poles in the dipole-dipole arrangement, by shifting the survey point position by switching the survey points along the survey line.

In this case, if the underground structure is not uniform, a value of specific resistance measured in the dipole-dipole arrangement is also changed with changes in an electrode interval, an electrode position, an electrode arrangement form and the like, and the value of the specific resistance to be measured loses a meaning as a true specific resistance value.

However, the value of specific resistance to be measured is an amount with some relation with the underground structure and is considered to be an apparent specific resistance value p obtained when the underground structure under an influence of the electrode system is regarded to be uniform.

Subsequently, the art of three-dimensionally displaying the position of the underground water in the underground water vein in the specific ground area related to the detection/check system 21 of an underground water vein and underground water in the underground water vein according to this embodiment so as to enable boring at a pinpoint will be described.

The detection/check system 21 of a water source in an underground water vein of this embodiment, that is, the art of three-dimensionally displaying the position of underground water in an underground water vein in a specific ground area so as to enable boring at a pinpoint has, as illustrated in FIGs. 24 and 25, a large number of electrodes group 22 (FIG. 24 illustrates each electrode 22a from the electrode numbers 0 to 20) disposed along a survey line of the specific ground area, a survey point switching unit 23 for executing horizontal exploration and underground vertical exploration of the specific ground area by a specific resistance method, the Wenner method by setting the electrodes with two poles (two poles of the electrode number 0 and the electrode number 3 in an example illustrated in FIG. 24) in the electrode with four poles (each electrode 22a from the electrode numbers 0 to 3 in the example illustrated in FIG. 24) in the dipole-dipole arrangement in the electrodes group 22 set to potential electrodes and the other two poles (two poles of the electrode number 1 and the electrode number 2 in the example illustrated in FIG. 24) to current electrodes and by combining and switching them, measuring means 25 for applying a voltage made of high and low two frequencies to a required number of electric cable groups 24 connecting each electrode 22a of the electrodes group 22 and the survey point switching unit 23 and the potential electrode with two poles in the dipole-dipole arrangement (electrode 2a with the electrode number 0 and the electrode number 3 at the first time) in an electrostatic capacitance switching method and making measurement for detecting a current for each of the high and low two frequencies flowing between the potential electrodes by the other current electrodes with two poles (electrode 22a with the electrode number 1 and the electrode number 2 at the first time) for each survey point of the entire specific ground area, specific resistance calculating means 31 for each survey point for calculating a specific resistance value for each of the high and low two frequencies in the horizontal and vertical directions at each survey point in the corresponding specific ground area on the basis of the voltage made of the high and low two frequencies and the currents detected for each of the high and low two frequencies, and impedance effect calculating means 41 for each survey point each for acquiring an impedance effect at each survey point made of (specific resistance value pH corresponding to the high frequency) / (specific resistance value pL corresponding to the low frequency) on the basis of the specific resistance values of each of the high and low two frequencies at each of the calculated survey points.

The measuring means 25, the specific resistance calculating means 31 for each survey point, the impedance effect calculating means 41 for each survey point are mounted on a measuring device 30 illustrated in FIGs. 24 and 25.

Moreover, it is configured that required power is supplied to the measuring device 30 by a battery B.

The lower column in FIG. 24 illustrates a display concept of an equivalent specific resistance line and an impedance effect which are exploration results of a specific ground area which can be drawn by the detection/check system 21 of an underground water vein and underground water in the underground water vein according to this embodiment.

And such estimation can be made possible that a survey point position of the impedance effect > 1 has the underground water vein.

Subsequently, detailed configuration of particularly the measuring device 30 in the detection/check system 21 of an underground water vein and underground water in the underground water vein according to this embodiment will be described by referring to FIG. 25.

The measuring device 30 has a program memory 26 storing an operation program of the detection/check system 21 of an underground water vein and underground water in the underground water vein according to this embodiment, a control portion 27 for executing entire control on the basis of the operation program, a variable frequency voltage output/detected current processing portion 28 configuring the measuring means 25, outputting a voltage at each survey point made of high and low two frequencies to the survey point switching unit 23, transmitting a value of the voltage at each survey point to the control portion 27, and transmitting a value of the detected current at each survey point from the current electrode to the control portion 27, and a frequency switch 29 for switching the frequency of the voltage at each survey point output by the variable frequency voltage output/detected current processing portion 28 to the high and low two frequencies (high frequency at 40 Hz and low frequency at 4Hz, for example).

Moreover, the measuring device 30 has a voltage/current storage portion 34 for each survey point for storing a value of the voltage at each survey point and a value of the current at each survey point transmitted through the control portion 27, a specific resistance calculation portion 32 for each survey point for calculating the specific resistance values p40 and p4 at each survey point on the basis of the voltage and current and a specific resistance storage portion 33 for each survey point for storing a calculation result of the specific resistance calculation portion 32 for each survey point configuring the specific resistance calculating means 31 for each survey point, and an impedance effect calculation portion 42 for each survey point configuring the impedance effect calculating means 41 for each survey point and calculating a value of an impedance effect (p40/p4) at each survey point on the basis of the specific resistance values p40 and p4 at each survey point and an impedance effect storage portion 43 for each survey point for storing a calculation result of the impedance effect calculation portion 42 at each survey point.

Moreover, the measuring device 30 includes a display portion 44 for displaying various letters and images, an equivalent specific resistance diagram for each survey point/impedance effect for each survey point drawing processing portion 45 for drawing an equivalent specific resistance diagram for each survey point corresponding to the specific resistance values p40 and p4 for each survey point on the basis of the operation program and an impedance effect diagram corresponding to the impedance effect (p40/p4) at each survey point on a screen of the display portion 44, an input operation portion 46 for performing an input operation such as various letters, and the battery B.

Subsequently, a series of processes of the ground exploration by the detection/check system 1 for an underground water vein and underground water in the underground water vein of this embodiment will be described.

In the ground exploration by the detection/check system 21 of an underground water vein and underground water in the underground water vein of this embodiment, each electrode 22a in the electrodes group 22 is continuously disposed at equal intervals along the survey line set in advance in a specific ground area, and each electrode 22a and the survey point switching unit 23 are connected by a required number of electric cable groups 24.

Subsequently, on a start point side of the large number of electrodes 22a continuously disposed at equal intervals, the four poles in the dipole-dipole arrangement are combined, voltages of high and low two frequencies of 40 Hz and 4 Hz, for example, are individually applied to the potential electrode with two poles in the four poles, and while the current flowing through the remaining current electrodes with two poles is measured, respectively, switching is made by the survey point switching unit 23, and the processing is proceeded with to the end side, and when one row of measurements is finished, the electrode interval is changed, and the similar measurement is made along the subsequent survey line.

Then, the voltage of the high and low two frequencies at each survey point and the current at each corresponding survey point are stored in the voltage/current storage portion 34 for each survey point, and the specific resistance values p40 and p4 at each survey point are calculated by the specific resistance calculation portion 32 for each survey point on the basis of them, and the calculation result is stored in the specific resistance storage portion 33 for each survey point.

When the measurement in the dipole-dipole arrangement is finished, the vertical exploration in the Wenner arrangement (or Schlumberger arrangement) is performed with additional connection for a required portion by using the electrodes as they are, and similarly to the aforementioned case, the specific resistance values p40 and p4 at each survey point are calculated by the specific resistance calculation portion 32 for each survey point, and the calculation result is also stored in the specific resistance storage portion 33 for each survey point. In this way, a schematic geological structure of the specific ground area is known.

At this time, the equivalent specific resistance value and a depth of a topsoil are employed as they are, and a deep portion is handled as an equivalent horizontal layer.

Subsequently, one of the acquired specific resistance value (the specific resistance value p40, for example) in the specific resistance values p40 and p4 for each of the two frequencies measured in the dipole-dipole arrangement is plotted to the depth immediately below each center point on the screen of the display portion 44 by the equivalent specific resistance diagram for each survey point/impedance effect for each survey point drawing processing portion 45 so as to draw the equivalent specific resistance diagram of the vertical section corresponding to the survey line, and the geological features are determined together with the Wenner method.

Subsequently, the value of the impedance effect (p40/p4) at each point is calculated by the impedance effect calculation portion 42 for each survey point on the basis of the specific resistance values p40 and p4 for each of the two frequencies at each point on the vertical section and stored in the impedance effect storage portion 43 for each survey point, while the value of each impedance effect (p40/p4) is also drawn at the depth immediately below the center point, respectively, on the screen of the display portion 44 by the equivalent specific resistance diagram for each survey point/impedance effect for each survey point drawing processing portion 45, the impedance effect diagram is drawn, and the impedance effect diagram is analyzed so as to know the position of the underground water vein with the impedance effect (p40/p4) > 1.

Determination that a favorable underground water vein is present at the position of the survey point having the impedance effect (p40/p4) > 1 is obtained by experiences through actual ground explorations by the inventors.

Subsequently, actual exploration results in specific ground areas in Japan, for example, using the detection/check system 21 of an underground water vein and underground water in the underground water vein of this embodiment will be described by referring to FIGs. 26 to 28.

FIG. 26 illustrates an specific resistance value by the Wennner method (upper column), the equivalent specific resistance diagram by the dipole-dipole method (middle column), the impedance effect diagram (lower column), and a distribution diagram (columnar diagram) of rocks and the like corresponding to the depth in Japan; A ground area, for example, obtained by using the detection/check system 21 for an underground water vein and underground water in the underground water vein of this embodiment.

### Exploration result by Wenner method

As is obvious from the upper column in FIG. 26, in Japan; A ground area, for example, the result is as follows:
Depth 0.0 to 4.2 m: alluvial lowland deposit cohesive soil (specific resistance: 28 Ωm)
Depth 4.2 to 11.0 m: alluvial lowland deposit sandy soil (specific resistance: 90 Ωm)
Depth 11.0 to 19.0 m: cohesive soil (specific resistance: 31 Ωm)
Depth 19.0 to 50 m: tuff breccia (specific resistance: 300 Ω)
Depth 50 m or more: sandstone shale

### Exploration result by equivalent specific resistance diagram by dipole-dipole method

As is obvious from the middle column in FIG. 26, in Japan; A ground area, the start point side from the survey point 40 has a sandy gravel layer to the neighborhood of the depth 20 m, cohesive soil to the neighborhood of 30 m, and high specific resistance (136 to 150 Ωm) at the survey points 150 to 155, depth 20 to 30 m is influenced by the river on three surfaces, the depth 20 to 50 m has slightly high specific resistance and tuff breccia, and it is distributed to the ground surface part on the end point side.

### Exploration result by impedance effect diagram

As is obvious from the lower column in FIG. 26, in Japan; A ground area, the underground water vein shows the impedance effect (p40/p4) > 1.1 of more.
Survey point 85, depth 60 to 70 m or more
Survey point 105 to 115, depth 60 to 80 m or more
Survey point 140, depth 40 to 50 m or more
Each of the areas is prospective and appropriate for test well.

In the equivalent specific resistance diagram by the dipole-dipole method and the impedance effect diagram, a lateral axis indicates the survey point 0 to 200, and a vertical axis to the depth 0 to 90 m.

Distribution of rocks and stones corresponding to the depth in the aforementioned A ground area is illustrated as a columnar diagram in the rightmost column in FIG. 26.

After the analysis, boring was performed at a survey point 110 line, and an underground water vein of 400 cubic meter/min was discovered.

FIG. 27 illustrates the equivalent specific resistance diagram by the dipole-dipole method (upper column), the impedance effect diagram (lower column), and the distribution diagram of rocks and stones corresponding to the depth in Japan; B ground area obtained by using the detection/check system 21 for an underground water vein and underground water in the underground water vein of this embodiment.

The exploration results are as follows.

In FIG. 27, a peak of a high specific resistance layer at a shallow spot at 80 to 100 Ωm, a sandy gravel layer to the neighborhood of the depth 10 m, shale for the specific resistance at 10 to 20 Ωm, alternation of sandy shale and sandy stone for the specific resistance at 20 to 50 Ωm, ununiformity with the Tertiary in the neighborhood of 120 m from the start point, and a left-downward normal fault were estimated.

Boring was performed at the position of the survey point 110 line including an error, targeted for the survey point 110 with the high impedance effect (p40/p4) at the depth 40 to 50 m and the neighborhood of the depth 70 m, and an underground water vein of 1.2 cubic meter/min was discovered.

Distribution of rocks and stones corresponding to the depth of the aforementioned B ground area is illustrated as the columnar diagram on the rightmost column in FIG. 27.

FIG. 28 illustrates the specific resistance value by the Wenner method (upper column), the equivalent specific resistance diagram by the dipole-dipole-method (middle column), the impedance effect diagram (lower column), and the distribution diagram (columnar diagram) of rocks and stones corresponding to the depth in Japan; C ground area, for example, obtained by using the detection/check system 21 for an underground water vein and underground water in the underground water vein of this embodiment.

### Exploration result by Wenner method

As is obvious from the upper column in FIG. 28, in Japan; C ground area, for example, the result was as follows.
Depth 0.8 to 1.7 m: sandy soil
Depth 1.7 to 6.5 m: sand and gravel
Depth 6.5 to 30.0 m: cohesive soil
Depth 30.0 to 60 m: diluvial sand and gravel
Depth 60 to 74 m: strongly weathered zone or fault
Depth 74 m and more: medium-hard rock
Each of the areas is prospective and appropriate for test well.

### Exploration result by equivalent specific resistance diagram of dipole-dipole method

As is obvious from the middle column n FIG. 28, there is a sandy gravel layer to the depth 6.6 m by the Wenner method and appears in the neighborhood of the depth 10 m due to the electrode interval.

The low specific resistance (120 Ωm or less) sandwiched in the depth 15 to 40 m has the lowest specific resistance value.

A spot from the depth 25 to 30 m has cohesive soil, and a part in a rising process is sandstone (a spot to the neighborhood of the depth 50 m is estimated to be a diluvial sand and gravel layer).

A right corner at the depth 50 m or below is basement rock, and a right-downward surface connecting a survey point 110 at the depth 50 m and a survey point 80 at the depth 70 m has a possibility of a fault surface.

A lower column in FIG. 28 illustrates an explanation result by the impedance effect diagram.

As is obvious from the lower column in FIG. 28, in Japan; C ground area, for example, the impedance effect (p40/p4) > 1 has a possibility of the underground water, but a test well is recommended at the depth 110 m and after for 30 m or deeper at survey points 85 to 120 where the specific resistance is high, and p40/p4 = 1.07 to 1.18 concentrates.

Distribution of rocks corresponding to the depth in the aforementioned C ground area is illustrated as a columnar diagram in the rightmost column in FIG. 28.

After the analysis, boring was performed at the survey point 100 line, and an underground water vein of 140 L/min was discovered.

FIG. 29 illustrates an exploration result of leakage spots in an earth dam in Japan; D ground area, for example, obtained by using the detection/check system 21 for an underground water vein and underground water in the underground water vein of this embodiment, in which an upper column in the figure illustrates an equivalent specific resistance diagram by the dipole-dipole method in the D ground area, while a lower column in the figure for the impedance effect diagram.

On the basis of the impedance effect diagram in the lower column in the figure, eight small leakage spots and two big leakage spots were discovered.

As described above, the detection/check system 21 for an underground water vein and underground water in the underground water vein of this embodiment is also effective for exploration of a leakage spot in a ground area where an underground pipe is present in a dam or the like.

The detection/check system 21 for an underground water vein and underground water in the underground water vein of this embodiment exerts a novel effect that the underground water vein can be estimated and checked by electric exploration from the ground surface at a pinpoint without actually performing boring in a specific ground area.

Moreover, it also has advantages that accurate detection/check of underground water in an underground water vein can be realized regardless of presence of inclination of a specific ground area, and the underground water in the underground water vein in the specific ground area can be detected/checked at a price extremely lower than that of the conventional boring method.

As described above, the art for realizing the detection/check system 21 for an underground water vein and underground water in the underground water vein the specific ground area according to the present invention, that is, the position of the underground water in the underground water vein which planarly and two-dimensionally visualizes the underground water vein can be displayed three-dimensionally and at a pinpoint.

That is, the system of three-dimensionally displaying a position of the underground water in a specific ground area at a pinpoint can be realized by configuration having a large number of electrodes group disposed along a survey line in the specific ground area, a survey point switching unit for executing horizontal exploration and underground vertical exploration of the specific ground area by the specific resistance method, the Wenner method by setting two poles of the electrode with four poles in the dipole-dipole arrangement in the electrodes group to potential electrodes and the other two poles to current electrodes and combining and switching them, measuring means for applying a voltage made of high and low two frequencies to the potential electrode with two poles in the dipole-dipole arrangement and making measurement for detecting a current for each of the high and low two frequencies flowing between the potential electrodes by the current electrode with the other two poles at each survey point of the entire specific ground area, specific resistance calculating means for each survey point for calculating a specific resistance value for each of the high and low two frequencies in the horizontal and vertical directions at each survey point in the corresponding specific ground area on the basis of the voltage made of the high and low two frequencies and the currents detected for each of the high and low two frequencies for each survey point, and impedance effect calculating means for each of the high and low two frequencies for acquiring an impedance effect at each of the survey points, made of (specific resistance value corresponding to the high frequency) / (specific resistance value corresponding to the low frequency) on the basis of the calculated specific resistance values of each of the high and low two frequencies at each of the survey points so that estimation that a survey point position of the impedance effect > 1 has an underground water vein can be made.

As described above, according to the present invention, the system that planarly and two-dimensionally visualizes the underground water vein in the specific ground area and three-dimensionally displays the position of the underground water in the visualized underground water vein so as to enable boring at a pinpoint can be realized.

### [Industrial Applicability]

The four-dimensional water circulation reproduction/analysis/prediction/visualization simulation system described above can be used for reproduction/analysis/prediction/visualization of the water circulation in a certain geosphere in Japan as described above, for example, and can be also applied to international contribution by being used for reproduction/analysis/prediction/visualization of the water circulation in a specific area in foreign countries, for example, and moreover, the aforementioned detection/check system 21 for an underground water vein and underground water in the underground water vein can be widely used for detection and check of the underground water in the underground water vein in a specific ground area or underground water or for detection and check of underground leakage in a ground area in which an underground water pipe is buried in a dam or the like.

### Reference Signs List

- 1: four-dimensional water circulation reproduction/analysis/prediction/visualization simulation system
- 11: control portion
- 12: program memory
- 13: database
- 14: calculation portion
- 15: image generation processing portion
- 16: simulation result storage portion
- 17: keyboard
- 18: mouse
- 19: color printer
- 20: display portion
- 21: detection/check system of underground water vein and underground water in the underground water vein
- 22: electrodes group
- 22a: electrode
- 23: survey point switching unit
- 24: electric cable group
- 25: measuring means
- 26: program memory
- 27: control portion
- 28: variable frequency voltage output/detected current processing portion
- 29: frequency switch
- 30: measuring device
- 31: specific resistance calculating means for each survey point
- 32: specific resistance calculation portion for each survey point
- 33: specific resistance storage portion for each survey point
- 34: voltage/current storage portion for each survey point
- 41: impedance effect calculating means for each survey point
- 42: impedance effect calculation portion for each survey point
- 43: impedance effect storage portion for each survey point
- 44: display portion
- 45: equivalent specific resistance diagram for each survey point/impedance effect for each survey point drawing processing portion
- 46: input operation portion
- B: battery

## Claims

1. A detection/check system of an underground water vein and underground water in the underground water vein which can three-dimensionally display a position of the underground water in the underground water vein at pinpoint while the underground water vein in a specific ground area is visualized planarly and two-dimensionally by
a four-dimensional water circulation reproduction/analysis/prediction/visualization simulation system for reproduction/analysis/prediction/visualization of a four-dimensional water circulation state from past to future regarding an underground water vein in the specific ground area is executed planarly and two-dimensionally, configured that
a three-dimensional landform/geological feature model including ground surfaces and underground in a specific ground area generated by using satellite image data, site survey data and existing published landform/geological feature data or either one of satellite image data and site survey data and existing published landform/geological feature data is stored in storage means,
an initialization model is generated by executing initialization processing with the underground of the three-dimensional landform/geological feature model set to a saturated zone through execution of a simulation program assembled on the basis of clarification of an analysis object for solving a water problem in demand,
simulation is executed by calculation processing by calculating means and image generation processing by image generation processing means in accordance with an input from input means of various parameters for reproduction of past/modern and current times and future prediction on the basis of execution of a simulation program to the initialization model,
the simulation result is verified by a numeral value analysis method, landform/geological feature analysis method, and historical fact comparison method and the like, and the landform/geological feature model and the like are modified as necessary so as to improve simulation accuracy,
and the simulation result is stored in in the storage means and is subjected to two-dimensional or three-dimensional still image and moving image processing and displayed on display means, and
a system which enables three-dimensional display of the position of the underground water in the underground water vein in the specific ground area at a pinpoint, having
a large number of electrodes group disposed along a survey line of the specific ground area,
a survey point switching unit for executing horizontal exploration and underground vertical exploration of the specific ground area by a specific resistance method by combining and switching electrodes with four poles in dipole-dipole arrangement in the electrodes group,
measuring means for applying a voltage made of high and low two frequencies to two poles of the electrode with four poles in the dipole-dipole arrangement and making measurement for detecting a current for each of the high and low two frequencies flowing between the two poles by the other two poles at each survey point of the entire specific ground area,
specific resistance calculating means for each survey point for calculating a specific resistance value for each of the high and low two frequencies in the horizontal and vertical directions at each survey point in the corresponding specific ground area on the basis of the voltage made of the high and low two frequencies and the currents detected for each of the high and low two frequencies, and
impedance effect calculating means for acquiring an impedance effect at each survey point, made of (specific resistance value corresponding to the high frequency) / (specific resistance value corresponding to the low frequency) on the basis of the calculated specific resistance values of each of the high and low two frequencies at each of the survey points so that estimation that a survey point position of the impedance effect > 1 has an underground water vein can be made.

2. A detection/check system of an underground water vein and underground water in an underground water vein which can three-dimensionally display a position of the underground water in the underground water vein at pinpoint while the underground water vein in a specific ground area is visualized planarly and two-dimensionally by
a four-dimensional water circulation reproduction/analysis/prediction/visualization simulation system for reproduction/analysis/prediction/visualization of a four-dimensional water circulation state from past to future regarding an underground water vein in the specific ground area is executed planarly and two-dimensionally, configured that
a three-dimensional landform/geological feature model including ground surfaces and underground in a specific ground area generated by using satellite image data, site survey data and existing published landform/geological feature data or either one of satellite image data and site survey data and existing published landform/geological feature data is stored in storage means,
an initialization model is generated by executing initialization processing with the underground of the three-dimensional landform/geological feature model set to a saturated zone through execution of a simulation program assembled on the basis of clarification of an analysis object for solving a water problem in demand,
simulation is executed by calculation processing by calculating means and image generation processing by image generation processing means in accordance with an input from input means of various parameters for reproduction of past/modern and current times and future prediction on the basis of execution of a simulation program to the initialization model,
the simulation result is verified by a numeral value analysis method, landform/geological feature analysis method, and historical fact comparison method and the like, and the landform/geological feature model and the like are modified as necessary so as to improve simulation accuracy,
and the simulation result is stored in in the storage means and is subjected to two-dimensional or three-dimensional still image and moving image processing and displayed on display means, and
a system which can three-dimensionally display the position of the underground water in the underground water vein in the specific ground area at a pinpoint, having
a large number of electrodes group disposed along a survey line of a specific ground area,
a survey point switching unit for executing horizontal exploration and underground vertical exploration of the specific ground area by a specific resistance method, a Wenner method by setting two poles of the electrode with four poles in dipole-dipole arrangement in the electrodes group to potential electrodes and the other two poles to current electrodes and combining and switching them,
measuring means for applying a voltage made of high and low two frequencies to the potential electrode with two poles in the dipole-dipole arrangement and making measurement for detecting a current for each of the high and low two frequencies flowing between the potential electrodes by the current electrode with the other two poles for each survey point of the entire specific ground area,
specific resistance calculating means for each survey point for calculating a specific resistance value for each of the high and low two frequencies in the horizontal and vertical directions at each survey point in the corresponding specific ground area on the basis of the voltage made of the high and low two frequencies and the currents detected for each of the high and low two frequencies, and
impedance effect calculating means for each of the high and low two frequencies at each of the survey points made of (specific resistance value corresponding to the high frequency) / (specific resistance value corresponding to the low frequency) on the basis of the calculated specific resistance values of each of the high and low two frequencies at each of the survey points so that estimation that a survey point position of the impedance effect > 1 has an underground water vein can be made.

3. The detection/check system of an underground water vein and underground water in the underground water vein according to claim 1 or 2, wherein
in the high and low two frequencies, the high frequency is 40 Hz and the low frequency is 4 Hz.
